(19)

Europäisches
Patentamt
European
Patent Office
Office européen
des brevets

(11)     **EP 1 215 783 B1**

(12)                          **EUROPEAN PATENT SPECIFICATION**

(45) Date of publication and mention
of the grant of the patent:
**13.10.2010   Bulletin 2010/41**

(51) Int Cl.:
*H01S 5/40* (2006.01)          *H01S 5/00* (2006.01)
*H01S 5/022* (2006.01)         *G02B 27/10* (2006.01)
*G02B 6/42* (2006.01)

(21) Application number: **01129992.2**

(22) Date of filing: **17.12.2001**

(54) **Semiconductor laser module, manufacturing method thereof and optical amplifier**

Halbleiterlasermodul, optische Verstärker und Herstellungsverfahren

Module laser à semi-conducteur, amplificateur optique et méthode de fabrication

(84) Designated Contracting States:
**DE FR GB IT**

(30) Priority: **15.12.2000   JP 2000381936
17.07.2001   JP 2001217265
23.10.2001   JP 2001325705**

(43) Date of publication of application:
**19.06.2002   Bulletin 2002/25**

(73) Proprietor: **THE FURUKAWA ELECTRIC CO., LTD.
Tokyo 100-8322 (JP)**

(72) Inventors:
• **Kimura, Toshio
Tokyo 100-8322 (JP)**
• **Nakae, Masashi
Tokyo 100-8322 (JP)**
• **Shimizu, Takeo
Tokyo 100-8322 (JP)**
• **Tsukiji, Naoki
Tokyo 100-8322 (JP)**
• **Yoshida, Junji
Tokyo 100-8322 (JP)**
• **Funabashi, Masaki
Tokyo 100-8322 (JP)**
• **Aikiyo, Takeshi
Tokyo 100-8322 (JP)**
• **Yamamoto, Toshiro
Tokyo 100-8322 (JP)**

• **Toratani, Tomoaki
Tokyo 100-8322 (JP)**
• **Matsuura, Hiroshi
Tokyo 100-8322 (JP)**
• **Konishi, Mieko
Tokyo 100-8322 (JP)**

(74) Representative: **Zimmermann, Gerd Heinrich et al
Zimmermann & Partner
Postfach 330 920
80069 München (DE)**

(56) References cited:
**EP-A- 0 312 652     GB-A- 2 313 234
US-A- 5 291 571     US-A- 5 589 684
US-A- 5 936 763**

• **PATENT ABSTRACTS OF JAPAN vol. 2000, no. 04, 31 August 2000 (2000-08-31) -& JP 2000 012952 A (NEC CORP), 14 January 2000 (2000-01-14)**
• **PATENT ABSTRACTS OF JAPAN vol. 2000, no. 04, 31 August 2000 (2000-08-31) -& JP 2000 031575 A (OKI ELECTRIC IND CO LTD), 28 January 2000 (2000-01-28)**
• **PATENT ABSTRACTS OF JAPAN vol. 1998, no. 08, 30 June 1998 (1998-06-30) -& JP 10 062720 A (OYO KODEN KENKIYUUSHITSU:KK), 6 March 1998 (1998-03-06)**

**Description**

BACKGROUND OF THE INVENTION

The present invention generally relates to a semiconductor laser module, a manufacturing method thereof a method for generating multiplexed laser beams and an optical amplifier using the semiconductor laser module. More particularly, the present invention relates to a semiconductor laser module including at least two laser beams, a manufacturing method thereof, and an optical amplifier using the semiconductor laser module.

With progresses in the optical communications based on a dense wavelength division multiplexing transmission system over the recent years, a higher output is increasingly demanded to a pumping light source used for the optical amplifier.

Further, a greater expectation is recently given to a Raman amplifier as an amplifier for amplifying the beams having a much broader band than by an erbium-doped optical amplifier that has hitherto been used as the optical amplifier. The Raman amplification may be defined as a method of amplifying the optical signals, which utilizes such a phenomenon that a gain occurs on the side of frequencies as low as 13 THz on the basis of a pumping beam wavelength due to the stimulated Raman scattering occurred when the pumping beams enter an optical fiber, and, when the signal beams having the wavelength range containing the gain described above are inputted to the optical fiber in the thus pumped (excited) state, these signal beams are amplified.

According to the Raman amplification, the signal beams are amplified in a state where a polarizing direction of the signal beams is coincident with a polarizing direction of the pumping beams, and it is therefore required that an influence by a deviation between polarizing planes of the signal beam and of the pumping beam be minimized. For attaining this, a degree of polarization (DOP) has hitherto been reduced by obviating the polarization of the pumping beam (which may be called depolarization).

As a method for simultaneously realizing a higher output and depolarization of a pumping light source, as disclosed in US Patent No. 5589684, a method in which a laser beam emitted from two semiconductor laser modules oscillating on the same wavelength is polarization-synthesized by a polarization synthesizing coupler is known.

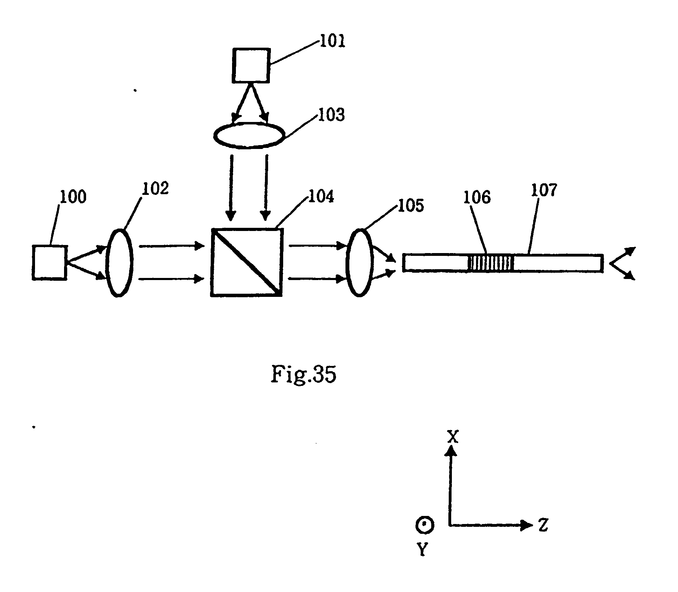

Fig. 35 is an explanatory view in explaining a conventional semiconductor laser apparatus disclosed in US Patent No. 5589684.

As shown in Fig. 35, a conventional semiconductor laser apparatus comprises: a first semiconductor laser device 100 and a second semiconductor laser device 101 for emitting laser beams in the orthogonal direction with each other on the same wavelength; a first collimation lens 102 for collimating the laser beam emitted from the first semiconductor laser device 100; a second collimation lens 103 for collimating the laser beam emitted from the second semiconductor laser device 101; a polarization synthesizing coupler 104 for orthogonally polarization-synthesizing the laser beam collimated by the first collimation lens 102 and the second collimation lens 103; a condenser lens 105 for condensing the laser beams polarization-synthesized by the polarization synthesizing coupler 104; and an optical fiber 107 with a fiber Bragg grating (FBG) 106 for receiving the laser beams condensed by the condenser lens 105 and letting the beams travel to the outside.

According to a conventional semiconductor laser apparatus, since the laser beams emitted in the orthogonal direction with each other from the first semiconductor laser device 100 and the second semiconductor laser device 101 are polarization-synthesized by the polarization synthesizing coupler 104, a laser beam whose degree of polarization is small can be emitted from the optical fiber 107. Furthermore, since fiber Bragg grating 106 is formed in the optical fiber 107, oscillation wavelengths of the semiconductor laser devices 100 and 101 are fixed in the same degree, a laser beam whose wavelength is fixed can be emitted from the optical fiber 107.

Accordingly, the above-mentioned conventional semiconductor laser apparatus can be applied as a pumping light source of an optical amplifier which requires a high optical output, especially of a Raman amplifier, which requires a low polarization dependency and a wavelength stability.

For example document US 5,291,571 discloses a duplicated light source module constructed so that rays of light emitted from two light sources pass through one lens and then enter one optical fiber through a birefringent element. This module is said to be useful when a light source in an optical transmitter is intended to be duplicated or when a high-power pumping source in an optical fiber amplifier is required. Thereby, however two semiconductor devices are used as light sources. Further, the lens is used to focus the beams onto a common spot.

For example JP-A-2000 012 952 discloses a manufacturing method by which a semiconductor optical waveguide array provided with a plurality of optical waveguides, obtained by selectively growing a multilayered semiconductor structure having a quantum well layer or another multilayered semiconductor structure composed of bulk layers into crystals in stripe-like growing regions 1 can be manufactured. In this method, each of the stripe-like growing regions 1 extended in parallel is formed between dielectric thin films and, when the multilayered semiconductor structure is selectively grown into the crystals by the metal organic vapor growth method in each growing region 1, each region 1 is formed in parallel with another at an interval which is shorter that the diffusing length of the raw material species in a reaction tube, when the crystals are grown. In addition, the widths Wm1 and Wm2 of the first and second outermost dielectric thin films respectively arranged on the outsides of the two outermost growing regions 1 are made narrower than a width Wa (Wm1>Wa and Wm2>Wa) of each dielectric thin film which is formed between growing regions 1. However, D3 fails to provide a solution for a scaled-down optics which is easy to manufacture.

What is known as a conventional semiconductor laser module used as a pumping light source or the like of an optical amplifier, is a semiconductor laser module in which two fluxes of laser beams are polarization-synthesized and thus outputted from an optical fiber.

For example, Japanese Patent Application Laid-open No. Sho 60-76707 discloses a semiconductor laser module including first and second semiconductor laser devices, a polarization rotating element, a polarization synthesizing element (calcite polarizer), and optical fiber and a lens. The first and second semiconductor laser devices having their optical axes and polarizing planes that are parallel to each other and also their exit edge surfaces substantially coincident with each other, are disposed on a heat sink and emit first and second laser beams, respectively. The polarization rotating element is disposed on a optical path for the first laser beam emitted from the first semiconductor laser device, and sets the polarizing plane of the first laser beam at a right angle to the polarizing plane of the second laser beam by rotating the former polarizing plane by 90°. The polarization synthesizing element serves to synthesize the optical paths for the first and second laser beams with the polarizing planes orthogonal to each other based on a birefringence effect. The optical fiber serves to receive the laser beams emerging from the polarization synthesizing element and let the laser beams travel outside. The lens serves to lead the laser beams synthesized by the polarization synthesizing element to the optical fiber. According to this semiconductor laser module, the first and second semiconductor laser devices are packaged as a unit (this technology will hereinafter be called a prior art 1).

Further, Japanese Patent Publication No. 10-062720 provides a polarized wave synthesis/demultiplexing module with a lens of a focus distance f, a first and a second waveguide means, and 2x1 optical elements. The first and second waveguide means are positioned so that at least one-end pair of them become parallel with each other and also face a first surface of the lens at a position where the end faces of the one-end pair satisfy a relationship 1/a+1/b=1/f.

Further, Japanese Patent Application Laid-open No. 2000-31575 discloses a semiconductor laser module including a cooling device (thermo-electric cooler), first and second semiconductor laser devices mounted on the cooling device, first and second condenser lenses each for converging first and second laser beams emitted from the first and second semiconductor laser devices, a polarization-synthesizing element for polarization-synthesizing the first and second laser beams, and an optical fiber for receiving the laser beams emerging from the polarization-synthesizing element and letting the laser beams travel outside. Moreover, each of the first and second semiconductor laser devices is constructed as an LD (laser diode) array in which the laser diodes are arrayed at a pitch between center portions of emission parts on the order of 500 $\mu$m. Further, each of the first and second condenser lenses is configured as a lens array for converging the laser beams such as a spherical lens array, a Fresnel lens array and so on (this technology will hereinafter be called a prior art 2).

The prior art 1 has the configuration in which the laser beams from the semiconductor laser device are received directly by the polarization rotating element or the polarization synthesizing element. The obtainment of a high optical coupling efficiency with the configuration of the prior art 1 therefore involves a geometrical design in which a space between the semiconductor laser device and the lens is set on the order of 300 to 500 $\mu$m. In fact, however, it is highly difficult to dispose the polarization rotating element and the polarization synthesizing element between the semiconductor laser device and the lens. A wider space can be formed by increasing a size of the lens, however, there remains a problem in that a size of the package becomes several times as large as package used at the present, which leads to a scale-up of the semiconductor laser module.

On the other hand, the prior art 2 has the configuration that the condenser lenses are disposed corresponding to the two semiconductor laser devices and thereafter the laser beams are polarization-synthesized, and therefore obviates the problem of the space in the prior art 1.

In the configuration, and as recognized by the prior inventors however, each lens receives one beam emitted at a comparatively wide interval (the inter-emission-center pitch; 500 $\mu$m) respectively, thereby obtaining the two laser beams parallel to each other. This configuration consequently brings about the scale-up of the semiconductor laser device with the result that a quantity of the semiconductor chips acquired from one sheet of wafer decreases, and is therefore unsuited to mass-production. If a space between the stripes of the semiconductor laser device is set to be narrow in order to obviate this problem, the lens needs downsizing, and the beams emerging from the respective stripes are hard to split from each other. It is therefore difficult to perform the subsequent polarization synthesization.

Further, it is required that the lens be positioned with respect to each of the laser beam emitted from the semiconductor laser device, and hence the problem arises herein that a manufacturing process becomes complicated, and the manufacturing is time-consuming. According to the prior art 2, the lens includes the use of a lens array (such as a spherical lens array or, a Fresnel lens array) that is normally unused in order to obviate the positioning difficulty. The prior art 2 therefore has such a problem that the manufacturing cost is high, and it takes much time to manufacture.

The present invention intends to overcome the above problems. The object is solved by the semiconductor laser module according to independent claim 1. Preferred embodiments are defined in the dependent claims.

Further advantages, features, aspects and details of the invention are evident from the dependent claims, the description and the accompanying drawings.

More particularly, the present invention relates to a semiconductor laser module including at least two laser beams.

A more complete appreciation of the invention and many of the attendant advantages thereof will be readily obtained as the same becomes better understood by reference to the following detailed description when considered in connection with the accompanying drawings, wherein:

FIG 1(A) is a side sectional view showing a configuration of a semiconductor laser module in accordance with a first embodiment of the present invention; FIG. 1(B) is a side view showing a state where a semiconductor laser device is fixed onto a heat sink;

FIG 2 is an explanatory diagram schematically showing a configuration of the semiconductor laser module in accordance with the first embodiment of the present invention;.

FIG 3(A) is a side view showing a configuration of a prism; FIG 3(B) is a plan view thereof;

FIG 4(A) is a plan view showing a polarization synthesizing module; FIG 4(B) is a side sectional view thereof; FIG 4(C) is a front view thereof;

FIG. 5 is a graph showing a spectrum when a drive current 2A (1A applied per stripe) is applied in a double-stripe type semiconductor laser module;

FIG 6 is a graph showing a fiber output versus an LD drive current in the double-stripe type semiconductor laser module;

FIGS. 7(A) and 7(B) are explanatory diagrams showing a step of aligning a first lens;

FIGS. 8(A) to 8(C) are explanatory views showing a configuration of the semiconductor laser device; FIGS. 8(B) and 8(C) are sectional views each taken along the line a-a in FIG 8(A);

FIG 9 is an explanatory view showing another example of the semiconductor laser device;

FIG 10 is an explanatory diagram schematically showing a configuration of the semiconductor laser module in accordance with a second embodiment of the present invention;

FIG 11 is an explanatory diagram schematically showing a configuration of the semiconductor laser module in accordance with a third embodiment of the present invention;

FIG 12 is a fragmentary perspective view showing a polarization synthesizing module in accordance with a fourth embodiment of the present invention;

FIG 13 is a side sectional view showing the polarization synthesizing module shown in FIG 12;

FIG 14 is an explanatory diagram schematically showing a semiconductor laser device in accordance with the fifth embodiment of the present invention;

FIGS. 15(A) to 15(C) are explanatory views showing a configuration of the semiconductor laser device in accordance with a sixth embodiment of the present invention;

FIGS. 15(B) and 15(C) are a sectional view taken along the line b-b in FIG 15(A) and a sectional view taken along the line c-c in FIG 15(A), respectively;

FIG. 16 is a graph showing a relationship between an oscillation spectrum and oscillation longitudinal modes in the semiconductor laser device in accordance with the sixth embodiment of the present invention;

FIGS. 17(A) and (B) are graphs showing a relationship in laser optical output power between a single oscillation longitudinal mode and a plurality of oscillation longitudinal modes, and a threshold value of stimulated Brillouin scattering;

FIGS. 18(A) to 18(C) are vertical sectional views each showing in the longitudinal direction a configuration of the semiconductor laser device in accordance with a seventh embodiment of the present invention;

FIG 19 is a vertical sectional view showing in the longitudinal direction a configuration of the semiconductor laser device in accordance with an eighth embodiment of the present invention;

FIG. 20 is an explanatory diagram showing a fluctuation in period of diffraction gratings provided in the semiconductor laser device shown in FIG 19;

FIG 21(a) to 21(c) are explanatory diagrams showing a modified example for actualizing the fluctuation in period of the diffraction gratings provided in the semiconductor laser device shown in FIG 19;

FIG 22(a) to (b) are explanatory diagrams schematically showing a configuration of the semiconductor laser module in accordance with an eleventh embodiment of the present invention;

FIG 23 is an explanatory diagram schematically showing a configuration of the semiconductor laser module in accordance with a twelfth embodiment of the present invention;

FIG 24 is an explanatory diagram schematically showing a configuration of the semiconductor laser module in accordance with a thirteenth embodiment of the present invention;

FIG 25 is an explanatory diagram schematically showing a configuration of the semiconductor laser module in accordance with a fourteenth embodiment of the present invention;

FIG 26(a) to 26(c) are explanatory diagrams showing an example of a photo diode (light receiving element) in accordance with a fifteenth embodiment of the present invention;

FIG 27(a) to 27(b) are explanatory diagrams schematically showing a configuration of the semiconductor laser module in accordance with a sixteenth embodiment of the present invention;

FIG 28 is a graph showing a beam transmissivity when entering a wavelength selection filter 7a;

FIG 29(a) to 29(b) are explanatory diagrams schematically showing a configuration of the semiconductor laser module in accordance with a seventeenth embodiment of the present invention;

FIG 30 is an explanatory diagram showing a wedge-shaped prism;

FIG. 31(a) to 31(b) are explanatory diagrams showing a optical path correction prism;

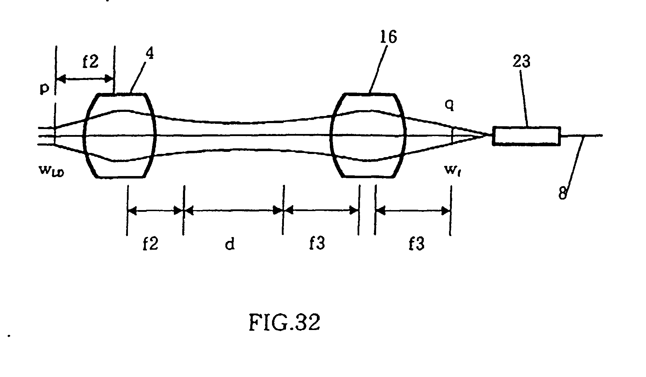

FIG 32 is an explanatory diagram showing coupling of Gaussian beams;

FIG 33 is a block diagram showing a configuration of a Raman amplifier in accordance with a eighteenth embodiment of the present invention;

FIG. 34 is a block diagram showing an architecture of a WDM communication system to which the Raman amplifier shown in FIG 33 is applied.

FIG.35 is a explanatory diagram showing a semiconductor laser module as disclosed in USP5,589,684.

Embodiments of the present invention will hereinafter be described with reference to the accompanying drawings.

(First Embodiment)

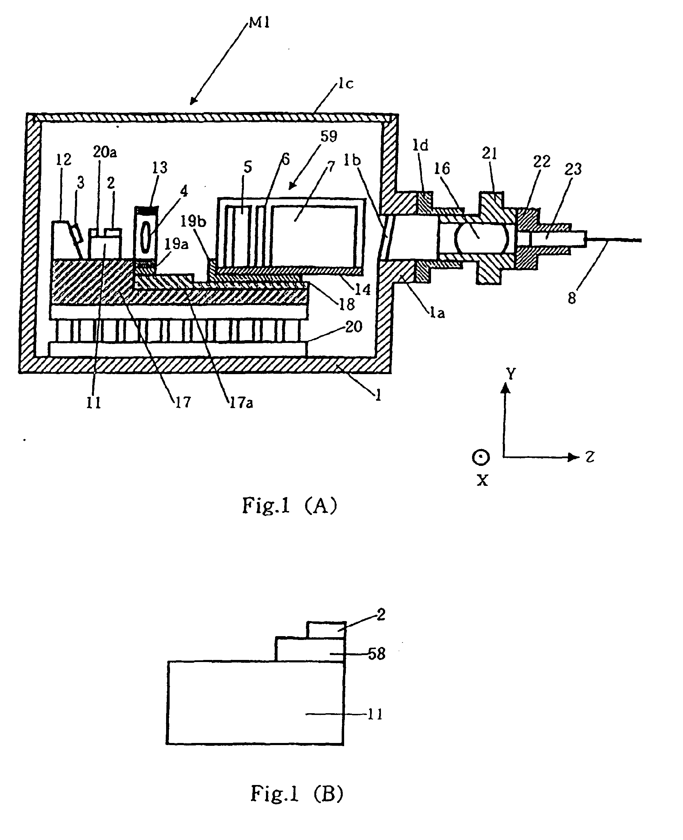

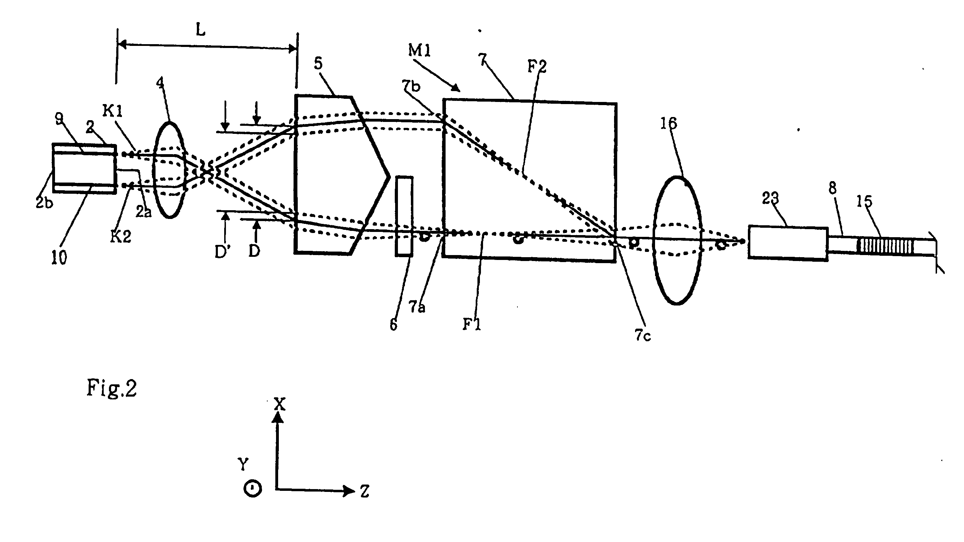

FIG 1(A) is a side sectional view showing a configuration of the semiconductor laser module in accordance with a first embodiment of the present invention. FIG 2 is an explanatory diagram schematically showing the configuration of the semiconductor laser module in accordance with the first embodiment of the present invention.

As shown in FIG 1(A), a semiconductor laser module M1 in accordance with the first embodiment of the present invention includes a package 1 of which an interior is hermetically sealed, a semiconductor laser device 2, encased in the package 1, for emitting laser beams, a photo diode (a light receiving element) 3, a first lens 4, a prism 5, a half-wave plate (a polarization rotating element) 6, a PBC (polarization beam combiner) 7 serving as an optical synthesizing element and an optical fiber 8.

The semiconductor laser device 2 includes, as shown in FIG. 2, a first stripe 9 (a stripe-shaped light emitting portion) and a second stripe 10 disposed with an interval on the same plane and extending in parallel in the longitudinal direction. The semiconductor laser device 2 emits a first laser beam K1 and a second laser beam K2 respectively from edge surfaces of the first and second stripes 9, 10. K1 and K2 shown in FIG 2 represent trajectories of the centers of the beams that exit the first and second stripes 9, 10, respectively. The beam travels, as indicated by a broken line in FIG 2, with some divergence (spread) about the center thereof. A space between the first stripe 9 and the second stripe 10 is set as 100 $\mu$m or less e.g., approximately 40-60 $\mu$m in order for the beams K1, K2 exiting these stripes 9, 10 to enter one piece of first lens 4. Moreover, the space between the stripes is narrow, whereby a difference in optical output characteristic between the stripes decreases.

As shown in FIG 1(A), the semiconductor laser device 2 is fixedly fitted onto a chip carrier 11. Note that the semiconductor laser device 2 emits the two laser beams K1, K2 and is therefore easier to become exothermic than a semiconductor laser device for emitting the single laser beam. It is therefore preferable that the semiconductor laser device 2 be fixedly fitted onto a heat sink 58 composed of a material exhibiting a high thermal-conductivity such as diamond and so forth, and that the heat sink 58 be fixedly fitted onto the chip carrier 11.

The photo diode 3 receives a monitor-oriented laser beam emitted from a rear (left side in FIG 1(A)) edge surface 2b (see FIG 2) of the semiconductor laser device 2. The photo diode 3 is fixedly attached to a photo diode carrier 12.

The first and second laser beams K1, K2 exiting a front (right side in FIG 1(A)) edge surface 2a of the semiconductor laser device 2 are incident upon the first lens 4. The first lens 4 functions so that these laser beams K1, K2 travel therethrough and intersect each other to subsequently split and expand in the arrayed direction of the stripes 9 and 10, and focuses these beams at different focal position F1, F2, respectively (see FIG 2).

Normally, parallel beams transformed into a large spot size have an angular tolerance that is as strict as 0.1° or smaller, however, the angular tolerance slackens in the condensing optical system which converges the laser beams at focal positions F1, F2 as described above. Since the first lens 4 is disposed as a condensing optical system in this embodiment, a manufacturing and positioning tolerance of the optical elements, as well as an angular adjusting tolerance of a beam are slack. This is a preferable aspect.

As shown in FIG 1(A), the first lens 4 is held by a first lens holding member 13. As shown in FIG 2, the first lens 4 is preferably positioned so that the optical axis of the first laser beam K1 emerging from the first stripe 9 and the optical axis of the second laser beam K2 emerging from the second stripe 10 show substantially a symmetry about the central axis of the first lens 4. With this arrangement, both of the first and second laser beams K1, K2 travel through the vicinity of the central axis of the first lens 4 that is defined as an area with a small aberration, and hence there is a decreased scatter on the wave surfaces of the laser beams, with the result that the optical coupling efficiency to the optical fiber 8 rises. As a result, a higher optical output may be obtained from the semiconductor laser module M1. Note that the first lens 4 preferably involves the use of an aspherical lens exhibiting a small spherical aberration for a high coupling efficiency to the optical fiber to be obtained.

The prism 5 is disposed between the first lens 4 and the PBC 7 and adjusts the optical paths, substantially collimates the optical axes, of the first and second laser beams K1, K2, thus letting the laser beams K1, K2 exit the prism 5 itself. The prism 5 is composed of an optical glass of BK7 (borosilicate crown glass) and so on. The optical axes of the first and second laser beams K1, K2 traveling in non-parallel from the first lens 4 are collimated by refraction of the prism 5, and hence the forming of the PBC 7 disposed in rear of the prism 5 is facilitated and it becomes feasible to downsize the semiconductor laser module M1 by downsizing the PBC 7.

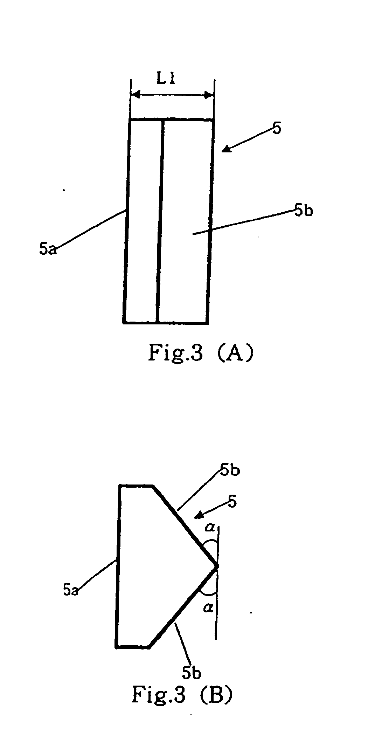

FIG 3(A) is a side view showing a configuration of the prism 5, and FIG. 3(B) is a plan view thereof. In FIGS. 3(A) and 3(B), the prism 5 includes an incident surface 5a formed flat and exit surfaces 5b inclined at a predetermined angle $\alpha$. For example, the prism 5 may be formed of BK7, the entire length L1 thereof may be approximately 1.0mm, and $\alpha$ may be designed to be $3.2° \pm 0.1°$, for the case of the stripes being spaced by $40\mu m$, and the focal length of the first lens being chosen to be 0.7mm.

As shown in FIG 2, the half-wave plate 6 admits an incidence of only the first laser beam K1 of the first and second laser beams K1, K2 passing through the prism 5, and rotates by 90 degrees a polarizing surface of the first laser beam K1 incident thereupon. The first lens 4 splits the first and second laser beams K1, K2 widely enough for the half-wave plate 6 to be able to be disposed easily.

The PBC 7 has a first input part 7a on which the first laser beam K1 is incident, a second input part 7b on which the second laser beam K2 is incident, and an output part 7c where the first laser beam entering the first input part 7a and the second laser beam K2 entering the second input part 7b are multiplexed (synthesized) and thus exit. The PBC 7 may be, for instance, a birefringence element through which the first laser beam K1 travels as an ordinary ray to the output part 7C and the second laser beam K2 travels as an extraordinary ray to the output part 7c. The PBC 7, if being the birefringence element, may be composed of, e.g., rutile ($TiO_2$) to obtain a high index of birefringence and a large split width between the laser beams.

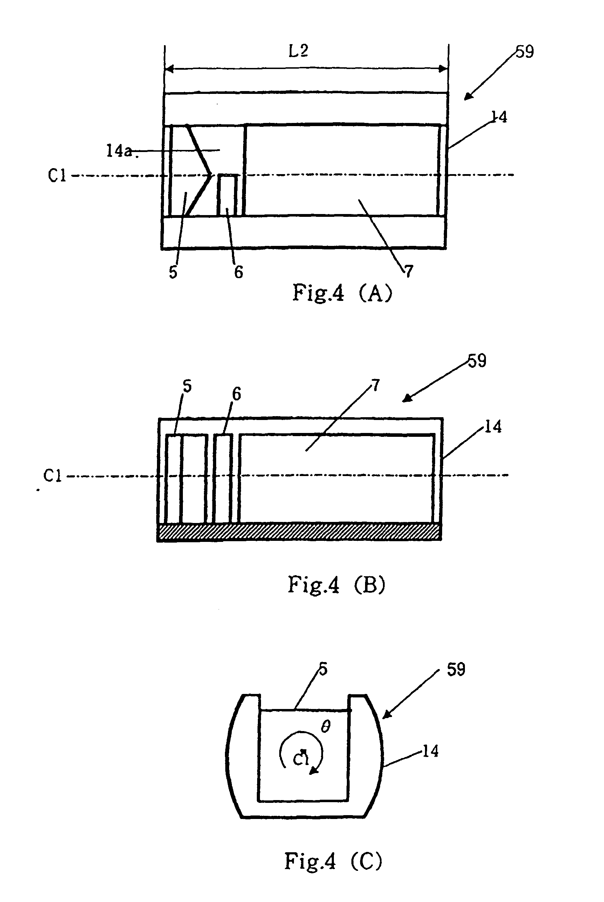

In the first embodiment, a polarization synthesizing module 59 is adopted in which the prism 5, the half-wave plate 6 and the PBC 7 are fixed to the same holder member 14. FIG. 4(A) is a plan view showing the polarization synthesizing module 59. FIG. 4(B) is a side sectional view thereof. FIG 4(C) is a front view thereof. As shown in FIGS. 4(A) to 4(C), the holder member 14 of the polarization synthesizing module 59 is composed of a material (for example, SUS403, SUS304 and so on) suitable for YAG laser welding. The holder member 14 is approximately 7.0 mm in its entire length L2 and is formed substantially in a cylindrical shape as a whole. The holder member 14 is formed inside with an rectanguler accommodation space 14a in which the prism 5, the half-wave plate 6 and the PBC 7 are fixedly provided, respectively. The holder member 14 is opened at its upper portion and is flat in its lower portion.

This configuration greatly facilitates adjusting the positions of the prism 5 and the PBC 7 about a central axis C1 so that both of the first laser beam K1 incident upon the first input part 7a of the PBC 7 and the second laser beam K2 incident upon the second input part 7b thereof, exit the output part 7c.

Thus, these optical elements are set integral within the holder member 14, and it is therefore possible to adjust a degree of how much the laser beams K1, K2 overlap with each other on the X-Y plane simply by moving the holder member 14.

As shown in FIG 2, the optical fiber 8 receives the laser beams exiting the output part 7c of the PBC 7 and lets the laser beams travel outside the package 1. The optical fiber 8 is, as shown in FIG 2, provided with a beam reflection element 15 consisting of an FBG (fiber bragg grating) that reflects the beams having a predetermined wavelength range. This beam reflection element 15 reflects the beams having the predetermined wavelength back to the semiconductor laser device 2. With this beam reflection element 15, an oscillation wavelength of the semiconductor laser device 2 is fixed, and an oscillation spectral width can be decreased. Accordingly, the laser beams emitted from the semiconductor laser modules M1 can be multiplexed with decreased loss at wavelength synthesizing coupler, and therefore, high output, multiplexed beams can be obtained which is suitable for use as a pumping light source of an erbium doped optical amplifier or a Raman amplifier. If used for a Raman amplifier, a fluctuation in gain of the Raman amplification can be restrained. The beam reflection element 15 is formed by irradiating a core of the optical fiber 8 with ultraviolet rays serving as interference fringes through, e.g., a phase mask, and consequently causing periodic changes in refractive index.

A second lens 16 for optically coupling the laser beams emerging from the output part 7c of the PBC 7 to the optical fiber 8, is disposed between the PBC 7 and the optical fiber 8. Preferably, the first lens 4 is positioned so that the first and second laser beams K1, K2 are focused on points (F1, F2) between the first lens 4 and the second lens 16. With this contrivance, a propagation distance L needed for the first and second laser beams K1, K2 to split widely enough for a half wave plate 6 to be able to be inserted only on the beam path of K1 (in other words, for a distance D' in FIG. 2 to take a sufficiently large value) is increased, because of the reduced beam spot sizes between the first lens 4 and focal points (F1, F2) which reduces overlapping of the two laser beams. Hence, a length of the semiconductor laser module M1 in the optical-axis direction can be reduced. As a result, it is feasible to provide the highly reliable semiconductor laser module M1 exhibiting an excellent stability over time of the optical coupling of the semiconductor laser device 2 to the optical fiber 8 under, e.g., a high-temperature environment.

As shown in FIG. 1, the chip carrier 11 to which the semiconductor laser device 2 is fixed and the photodiode carrier 12 to which the photo diode 3 is fixed, are fixed by soldering onto a first base plate 17 taking substantially an L-shape in section. It is preferable that the first base plate 17 be composed of a CuW based alloy and so on in order to enhance a capacity of transferring the heat evolved by the semiconductor laser device 2.

The first lens holding member 13 to which the first lens 4 is fixed and the polarization synthesizing module 59 with the prism 5, the half-wave plate 6 and the PBC 7 fixed to the holder member 14, are fixed by the YAG laser welding onto a second base plate 18 through a first support member 19a and a second support member 19b, respectively. It is therefore preferable that the second base plate 18 be formed of a stainless steel etc showing a high welding property. Further, the second base plate 18 is fixed by brazing onto a flat part 17a of the first base plate 17.

A cooling device (thermo-electric cooler) 20 constructed of a plurarity of Peltier elements are provided under the first base plate 17. A thermistor 20a provided on the chip carrier 11 detects a change in temperature due to the heat transferred from the semiconductor laser device 2. The cooling device 20 is controlled to keep constant the temperature detected by the thermistor 20a. This contrivance makes it feasible to increase and stabilize the output of emission of the laser beams from the semiconductor laser device 2.

A window 1b upon which the beams penetrating the PBC 7 are incident is provided inside the flange 1a formed at the side area of the package 1, and a second lens 16 for converging the laser beams is fixed at the end of the flange 1a. The second lens 16 is held by a second lens holding member 21 fixed by the YAG laser welding to a side edge of the flange 1a. A metallic slide ring 22 is fixed by the YAG laser welding to a side edge of the second lens holding member 21.

The optical fiber 8 is held by a ferrule 23 fixed by the YAG laser welding to an interior of the slide ring 22.

Next, operations of the semiconductor laser module M1 in accordance with the first embodiment of the present invention will be explained.

As shown in FIG 2, the first and second laser beams K1, K2 emitted from the front edge surfaces 2a of the first and second stripes 9, 10 of the semiconductor laser device 2, penetrate the first lens 4 and intersect each other. Thereafter, the laser beams K1, K2 having a sufficient divergence split thoroughly and then enter the prism 5. A width of divergence (D) between the first and second laser beams K1, K2 when entering the prism 5 is approximately 460$\mu$m. The first and second laser beams K1, K2 are collimated by the prism 5 and thus exit (the width of divergence between the laser beams K1 and K2 becomes approximately 500$\mu$m at the exit). Then, the first laser beam K1 impinges on the half-wave plate 6 and, after its polarization plane has been rotated by 90 degrees, enters the first input part 7a of the PBC 7, while the second laser beam K2 enters the second input part 7b of the PBC 7.

In the PBC 7, the first laser beam K1 emerging from the first input part 7a and the second laser beam K2 emerging from the second input part 7b, are multiplexed and exit the output part 7c.

The laser beams emitted from the PBC 7 are converged by the second lens 16, then incident upon the edge surface of the optical fiber 8 held by the ferrule 23, and propagate outside. Further, some proportion of the laser beams are reflected by the beam reflection element 15 of the optical fiber 8 back to the semiconductor laser device 2, thereby forming an external resonator between the rear edge surface 2b of the semiconductor laser device 2 and the beam reflection element 15. Hence, the laser oscillations with a wavelength determined by the beam reflection element 15 can occur.

The monitor-oriented laser beams emerging from the rear edge surface 2b of the semiconductor laser device 2, are received by the photo diode 3. An optical output or the like of the semiconductor laser device 2 is adjusted by changing the driving current applied to the semiconductor laser device 2 based on a light receiving quantity etc. of the photo diode 3.

According to the semiconductor laser module M1 in accordance with the first embodiment of the present invention, the first and second laser beams K1, K2 with their polarization planes coincident with each other are emitted from the first and second stripes 9, 10 formed at the space as narrow as 100 $\mu$m or less in the single semiconductor laser device 2. The first and second laser beams K1, K2 are thoroughly split from each other by the first lens 4, and thereafter the polarization plane of the first beam is rotated exactly by 90 degrees with the half-wave plate 6. Namely, the polarization planes of the laser beams K1, K2 make substantially completely 90° at this time. The first and second laser beams K1, K2 are polarization-synthesized by the PBC 7 in this state, and hence the laser beams having the high output and a small degree of polarization can be emitted out of the optical fiber 8. Further, the optical fiber 8 is formed with a beam reflection element 15 such as FBG, and therefore the laser beams with a fixed wavelength can be emitted out of the optical fiber 8. Accordingly, the semiconductor laser module M1 can be applied for the pumping light source for an erbium-doped optical amplifier of which a high output is demanded or for a Raman amplifier which is required to have a low polarization dependency of gain and a high gain stability.

Further, since the semiconductor laser module M1 uses one piece of semiconductor laser device 2 formed with two stripes for emitting two fluxes of laser beams and one piece of first lens 4 for splitting the two laser beams, it takes less time to position the semiconductor laser device 2 and the first lens 4. As a result, it is possible to reduce the time for manufacturing the semiconductor laser module M1.

Moreover, there has hitherto been the semiconductor laser module as disclosed in USP5,589,684, in which two pieces of semiconductor lasers emit the laser beams in the axial directions completely orthogonal to each other (refer to FIG.35). This type of semiconductor laser module is, however, if designed without taking a warp or the like of the package in the axial directions (a X direction and a Z direction in FIG.35) into account, incapable of restraining fluctuations in the optical output due to the warp of the package that arises in high temperature environment. By contrast, according to the configuration in the first embodiment, the two laser beams emitted from the single semiconductor laser device 2 travel substantially in the same direction, and hence the optical output of the laser beams emerging from the optical fiber 8 can be stabilized by restraining an influence of the warp of the package only in one direction (a Z-direction in FIG 2).

Further, the single semiconductor laser device 2 emits the two laser beams, and the coupling efficiencies of these two laser beams have the same tendency of fluctuations with respect to the package warp and so on. Accordingly, the degree of polarization of the laser beams emitted from the optical fiber 8 is stable over the temperature fluctuation.

Further, since the semiconductor laser module M1 uses a single semiconductor laser device 2, it is possible to downsize the cooling device 20 (e.g. a Peltier module) and to decrease the of electric power consumption.

Note that the electric power consumed when the cooling device 20 radiates a tremendous quantity of heat from the two stripes 9, 10 can be reduced to a large extent by creating a vacuum or filling Xe in the interior of the package 1.

Moreover, if a polarization maintaining fiber formed with the fiber Bragg grating (FBG) is attached to the semiconductor laser module emitting the two fluxes of laser beams ("double-stripe type semiconductor laser module") as in the first embodiment, more longitudinal modes can be contained within the spectral width than in the case of the single-stripe type semiconductor laser module emitting one flux of laser beam with the same magnitude of reflection bandwidth of FBG

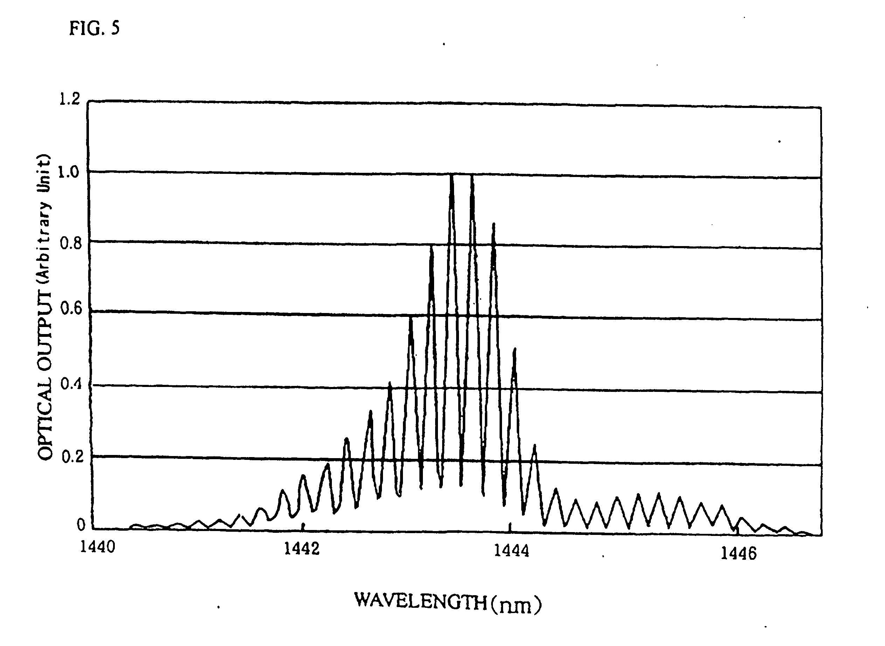

For instance, FIG. 5 is a graph showing an oscillation spectrum when applying a drive current of 2A (1A per stripe) to the double-stripe type semiconductor laser module M1. As can be understood from FIG. 5, five longitudinal modes are contained within the full width at half maximum (FWHM) of the spectrum of the double-stripe type semiconductor laser module M1. On the other hand, in the case of a single-stripe type semiconductor laser module, three or four longitudinal modes are contained within the FWHM of the oscillation spectrum at the drive current 1A.

Since the polarization maintaining fiber has a refractive index that differs depending on a slow-axis and a fast-axis, the reflection wavelengths selected in the two axes at the FBG differ from each other by about 0.4 nm. Hence, the spectrums from the two stripes, each emitting a spectrum different from the other by about 0.4nm, overlap to contain an increased number of longitudinal modes within the FWHM of the synthesized spectrum.

Note here that the semiconductor laser module according to this embodiment of the present invention emits a polarization-synthesized laser beam with lower DOP than laser beam from a single stripe. In case, however, that DOP is not sufficiently reduced, a output beam might be further depolarized by being transmitted through a length of a polarization maintaining fiber (depolarizer). Then, since the semiconductor laser module according to this embodiment oscillates in an increased number of longitudinal modes, the DOP can be effectively reduced while propagating through the depolarizer. Therefore the semiconductor laser module M1 is suitable as the pumping light source of Raman amplifiers which are required to have the low polarization dependency of gain.

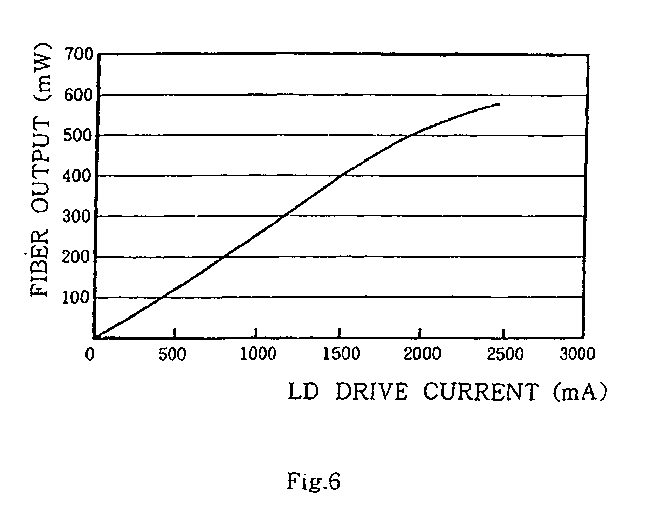

Further, the double-stripe type semiconductor laser module is capable of obtaining high optical output. FIG. 6 is a graph showing a fiber output versus a drive current to the semiconductor laser device in the double-stripe type semiconductor laser module. As can be understood from FIG 6, an eoptical output reaches 570 mW at the drive current is 2400 mA. Hence, the double-stripe typ semiconductor laser module in the first embodiment is suitable for use as a pumping light source in a band of 14XX (1300 to 1550) nm for Raman amplifiers, and also as the pumping light source in bands of 980 nm and 1480 nm for eibium doped fiber amplifiers (EDFA), both of which are required to have high optical output.

Next, a method of manufacturing the semiconductor laser module M1 in accordance with the first embodiment of the present invention will hereinafter be described.

To start with, the second base plate 18 is fixed by brazing onto the flat part 17a of the first base plate 17.

Subsequently, the chip carrier 11 to which the semiconductor laser device 2 is fixed and the photodiode carrier 12 to which the photo diode 3 is fixed, are fixed by soldering onto the first base plate 17.

Next, the first lens 4 is aligned and fixed onto the second base plate 18. In the aligning step of the first lens 4, the semiconductor laser device 2 is supplied with the electric current and emits the first and second laser beams K1, K2 from both of the first and second stripes 9, 10 of the semiconductor laser device 2. Then, after setting this beam emitting direction as a fiducial direction, the first lens 4 is inserted and positioned in the X-, Y- and Z-axis directions.

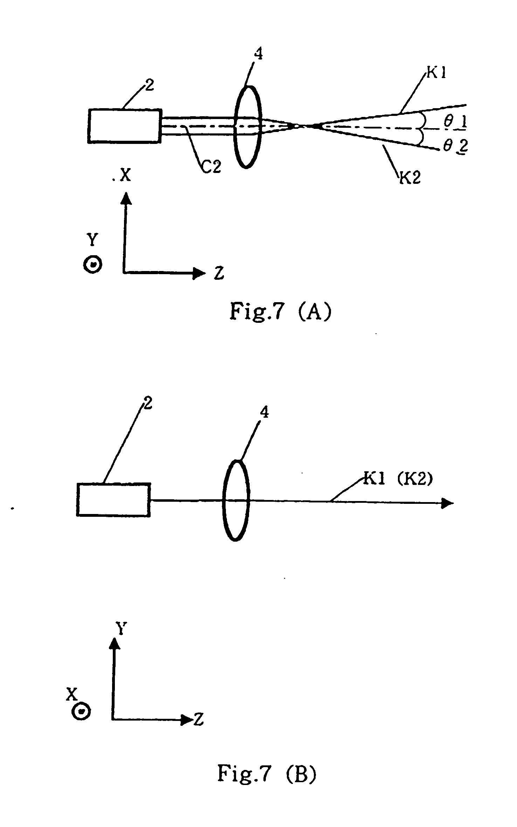

FIGS. 7 (A) and 7(B) are explanatory diagrams showing the aligning step of the first lens 4. The first lens 4 is, as shown in FIG 7(A), positioned in the X-axis direction so that an angle θ1 made between the fiducial direction (a central axis C2) set in the way described above and the first laser beam K1 is equal to an angle θ2 made between the central axis C2 and the second laser beam K2. The first lens 4 is, as shown in FIG 7(B), positioned in the Y-axis direction so that the first and second laser beams K1, K2 travel through the center of the first lens 4. Further, the first lens 4 is positioned in the Z-axis direction so that a spot size of the laser beam is minimized at a predetermined distance from the semiconductor laser device 2. The first lens holding member 13, which holds the first lens positioned in the aligning step described above, is fixed by the YAG laser welding onto the second base plate 18 through the first support member 19a.

Subsequently, the polarization synthesizing module 59 including the prism 5, the half-wave plate 6 and the PBC 7 as the integral unit on the whole, is aligned and fixed onto the second base plate 18. In this aligning step of the polarization synthesizing module 59, the polarization synthesizing module 59 is aligned in the X- Y- and Z-axis directions and rotated about angle θof the central axis C1 (see FIGS. 4(A) to 4(c)) of the holder member 14 so that an optical intensity of the beams coupled to the fiber collimator for positioning is maximized. The polarization synthesizing module 59 is adjusted in its position and then positioned about the central axis C1 of the holder member 14 by rotating the holder member 14 about the central axis C1 so that both of the first laser beams K1 entering the first input part 7a and the second laser beam K2 entering the second input part 7b, exit the output part 7c.

The polarization synthesizing module 59 is positioned in the Z-axis direction in a way that adjust the degree of how much the laser beams K1, K2 outputted from the PBC 7 overlap with each other on the X-Y plane. For example, the laser beams K1, K2 may completely overlap with each other, or they may partially overlap. In the latter case, if the laser beams K1, K2 have different optical intensities, the optical fiber 8 is aligned so as to receive a larger proportion of laser beam having the smaller optical intensity, thus equalizing the optical intensities of the laser beams K1, K2 entering the optical fiber 8. The degree of polarization can be thereby decreased sufficiently.

The holder member 14 is fixed by the YAG laser welding in the position determined in the aligning step described above onto the second base plate 18 through the second support member 19b.

Subsequently, the first base plate 17 is fixed by soldering onto the cooling device 20 which has been fixed beforehand onto a bottom plate of the package 1.

Then, the semiconductor laser device 2 and the photo diode 3 are electrically connected to leads (not shown) of the package 1 through a metal wires (unillustrated).

Next, a cover 1c is placed over the upper portion of the package 1 in an inert gas (e.g., $N_2$, Xe) atmosphere, and a peripheral edge portion thereof is resistance-welded, thereby hermetically sealing the package.

Subsequently, the second lens 16 is aligned within the X-Y plane and in the Z-axis direction and thus fixed to the flange 1a of the package 1. In this step, the second lens holding member 21 is fixed by YAG laser welding in such a position that the beam emerging from the second lens 16 is parallel to the central axis of the flange 1a of the package 1.

Finally, the optical fiber 8 is aligned and then fixed. In this step, the metallic slide ring 22 is fixed to the side edge of the second lens holding member 21. The slide ring 22 is adjusted in its position within the plane (the X-Y plane) perpendicular to the optical axis of the optical fiber 8 at the edge surface of the second lens holding member 21, and is thereafter fixed by YAG laser welding at a boundary therebetween. The ferrule 23 for holding the optical fiber 8 is fixed by YAG laser welding to an interior of the slide ring 22 in such a position that the beam emission from the optical fiber 8 is maximized. On this occasion, the optical fiber 8 is aligned taking a power balance of the plurality of laser beams to be synthesized into consideration. The position of the optical fiber 8 in the optical-axis direction (the z-axis direction) is thereby fixed.

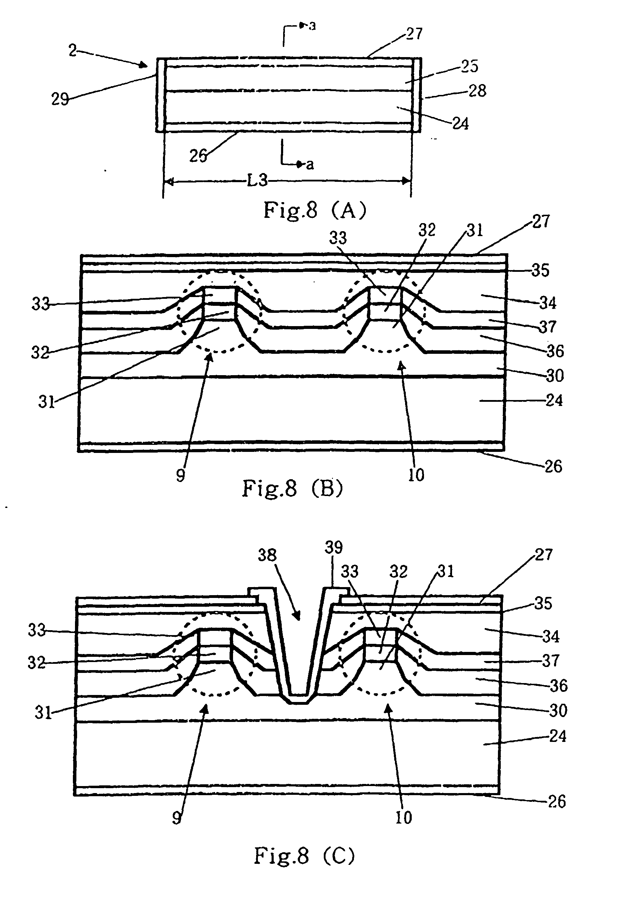

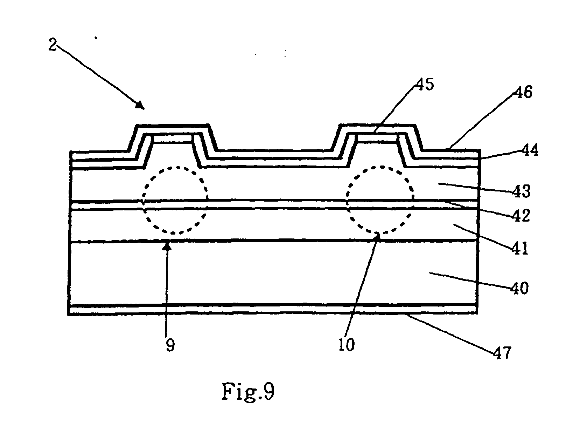

Now, the semiconductor laser device 2 used for the semiconductor laser module in accordance with the first embodiment of the present invention will be explained. FIGS. 8(A) to 8(C) are explanatory views showing the configuration of the semiconductor laser device 2 used for the semiconductor laser module of the present invention. FIG 9 is an explanatory view showing another example of the semiconductor laser device 2. Note that FIGS. 8(B) and 8(C) are the sectional views taken along the line a-a in FIG. 8(A).

As shown in FIG 8(A), the semiconductor laser device 2 is configured such that a lamination structure 25 is formed on a substrate 24 composed of a predetermined semiconductor by executing a predetermined semiconductor epitaxial crystal growth on the basis of a known epitaxial growth technique such as an organic metal vapor phase epitaxy, a liquid phase epitaxy, a molecular beam epitaxy and a gas source molecular beam epitaxy, thereafter a lower electrode 26 is formed on an undersurface of the substrate 24, an upper electrode 27 is formed on an upper surface of the lamination structure 25, a predetermined cavity length L3 is obtained by cleavage, further a low-reflection layer 28 (a reflectance is, e.g., 5% or smaller) is formed on one cleavage surface (the front edge surface 2a), and a high-reflection layer 29 (a reflectance is, e.g., 90% or larger) is formed on the other cleavage surface (the rear edge surface 2b).

As shown in FIG 8(B), the lamination structure 25 on the substrate 24 is, for instance, a BH (buried hetero) structure wherein e.g, n-InP clad layer 31, an active layer 32 consisting of GRIN-SCH-MQW (Graded Index Separate Confinement Heterostructure Multi Quantum Well) composed of multilayer of GaInAsP, and an p-InP clad layer 33 are sequentially laminated on the substrate composed of e.g., n-InP. And further an upper buried layer 34 composed of, e.g., p-InP and a cap layer 35 composed of, e.g., p-GaInAsP are laminated on the p-InP clad layer 33. Then, the upper electrode 27 and the lower electrode 26 are provided on the cap layer 35 and on the undersurface of the substrate 24, respectively.

The InP clad layer 31, the active layer 32 and the p-InP clad layer 33 are etched to two steaks of stripes arranged in parallel with each other with a space of 40-60 $\mu$m, and a current confinement region consisting of a p-InP layer 36 and an n-InP layer 37 are formed on the side faces of the stripes.

The active layer 32 involves, for instance, a compressive strain quantum well structure, wherein a lattice mismatch of well layers with respect to the substrate 24 is 0.5% or larger but is not larger than 1.5%. And the multi quantum well structure of well number of about 5 is preferably used for obtaining a higher output from a stripe. Further, the strained quantum well structure may adopt a strain compensation structure in which a barrier layer thereof takes a tensile strain which is opposite to the strain of the well layer, whereby the lattice match condition can be equivalently met, and a further higher value of the lattice mismatch in the well layer can be tolerated.

According to the first embodiment, the light emitting portions consisting of the n-InP clad layer 31, the GRIN-SCH-MQW active layer 32 and the p-InP clad layer 33 are formed extending in the form of stripes in the direction vertical to the sheet surface in FIG 8, and these portions are called the stripes 9 and 10, respectively.

Next, a method of manufacturing the semiconductor laser device 2 having the structure described above will be explained.

To begin with, the n-InP clad layer 31, the active layer 32, the p-InP clad layer 33 are laminated in this sequence on the substrate 24 by the known epitaxial growth technique such as the organic metal vapor phase epitaxy, the liquid phase epitaxy, the molecular beam epitaxy and the gas source molecular beam epitaxy.

Subsequently, two pieces of masks arranged in parallel with each other with a space of 40-60$\mu$m are provided on the p-InP clad layer 33. Thereafter, some portions of the p-InP clad layer 33, the active layer 32, the n-InP clad layer 31 and the substrate 24, are dissolved by use of a predetermined etchant (etching liquid), and the p-InP blocking layer 36 and the n-InP blocking layer 37 are laminated in this sequence on the sides of the stripes, thereby forming the current confinement region.

Subsequently, the upper buried layer 34 is grown by an epitaxial growth technique.

Further, the cap layer 35 is laminated on the upper buried layer 34.

Next, the upper electrode 27 is formed on the upper surface of the cap layer 35, and the lower electrode 26 is formed on the undersurface of the substrate 24.

Thereafter, the substrate is cleaved into bars with a width L3, thereby defining a cavity with the length L3. The low-reflection layer 28 is formed on one cleavage surface (the front edge surface 2a), and the high-reflection layer 29 is formed on the other cleavage surface (the rear edge surface 2b). Finally the bars are further cleaved into chips to obtain semiconductor laser devices 2.

In the thus manufactured semiconductor laser device 2, the side of the upper electrode 27 is bonded by AuSn-soldering to the heat sink 58 shown in FIG 1(B). Then, the laser oscillations occur simultaneously at the two stripes when supplied with the electric current from outside via the upper electrode 27 (on the p-side in the first embodiment) and the lower electrode 26 (on the n-side in the first embodiment), and the two fluxes of outgoing beams from the low-reflection layer 28 are multiplexed by the PBC 7 described above to be used for a desired application.

Supposing herein that the two stripes have absolutely the same characteristic, a threshold current of the semiconductor laser device 2 in the first embodiment is twice the threshold current of one single stripe, and the total optical output is twice the optical output of the single stripe. Namely, the semiconductor laser device 2 as a whole obtains approximately a 2-fold optical output with the drive current that is approximately twice the drive current per stripe, and a slope efficiency of the semiconductor laser device 2 is substantially the same as that of the semiconductor laser device 1 having one single stripe.

Note that the first embodiment discussed above has exemplified the structure in which the two stripes are simultaneously driven. As shown in, for example, FIG. 8(C), however, a separation trench 38 having a depth extending from the upper electrode 27 down to the lower clad layer 30, may be formed between the two stripes, and the surface of this separation trench 38 is covered with an insulation layer 39, whereby the two stripes can be electrically separated. If a lower electrode 26 sided portion of the semiconductor laser device 2 described above is bonded by AuSn-soldering to the unillustrated heat sink, the drive currents supplied to the two stripes can be independently controlled, thereby facilitating randomization of the polarization planes of the laser beams emitted from the optical fiber 8. In this case, at least one of the positive electrode side and the negative electrode side of each of the two stripes may be electrically insulated.

Note that the semiconductor laser device 2 as shown in FIG 8(C) may be used in such a way that a drive current is supplied to only one of the two stripes and the other stripe is supplied with current only after the active layer of the one stripe falls into an abnormal state. In this case, the other stripe is configured as a redundant system, and hence the semiconductor laser device 2 comes to have a longer product life-span.

Further, if used in a way such that the upper electrode 27 is bonded to the heat sink 58, an electrode may be formed beforehand on the heat sink 58 correspondingly to the upper electrode 27 so that those two stripes can be independently driven.

Further, the semiconductor laser device 2 in the first embodiment discussed above has been exemplified as having the InP-based BH (buried hetero) structure. However, there may also be used the semiconductor laser device 2 of, e.g., a GaAs-based ridge waveguide type as shown in FIG 9. As shown in FIG. 9, this semiconductor laser device 2 has a structure in which an n-type lower clad layer 41, an active layer 42, a p-type upper clad layer 43, an insulation layer 44, a p-GaAs layer 45 are laminated on a substrate 40 made of n-GaAs, and two ridges are formed. An upper electrode (p-type electrode) 46 is formed over the insulation layer 44 and the p-GaAs layer 45. A lower electrode (n-type electrode) 47 is formed on an undersurface of the substrate 40.

The ridges are formed extending in stripes in the direction vertical to the sheet surface in FIG 9. Each of the active layer streaks 42 just under along the ridges emits light. These light-emitting layer streaks are called the stripes 9 and 10, respectively. Of course, a InP ridge type LD can be used in this embodiment.

Furthermore, the first embodiment has exemplified the Fabry-Perot semiconductor laser device 2, which is the most basic form of the semiconductor laser device 2. However, the semiconductor laser device 2 may include a wavelength selecting element as will be mentioned later on. When using this type of semiconductor laser device 2, the optical output with a stabilized oscillation wavelength can be obtained without using an optical fiber with FBG

(Second Embodiment)

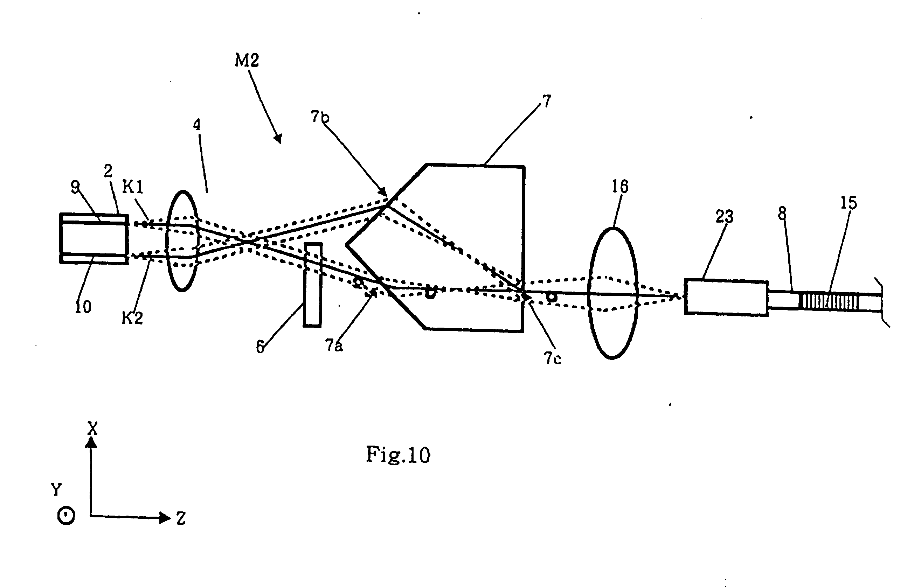

FIG 10 is an explanatory diagram schematically showing a configuration of a semiconductor laser module M2 in accordance with a second embodiment of the present invention. As shown in FIG 10, according to the second embodiment, incident surfaces of the PBC 7 upon which the first and second laser beams K1, K2 are incident are inclined in a wedge-like shape so that the first laser beam K1 travels as a normal ray in the axial-line direction of the optical fiber 8. Other than this point, this embodiment is substantially the same as the semiconductor laser module in the first embodiment.

According to the second embodiment, the first laser beam K1 travels as the normal ray in the axial-line direction of the optical fiber 8, and hence there is no necessity of providing the prism 5 between the half-wave plate 6 and the first lens 4, thereby making it possible to simplify the configuration and to reduce the length of the semiconductor laser module M2 in the optical-axis direction, making the optical output less susceptible to the warp of the package that arises in a high-temperature environment.

Note that the half-wave plate 6 and the PBC 7, which are fixed to the same holder member 14, may be structured as a polarization synthesizing module in order to facilitate the angular adjustment about the central axis also in the second embodiment.

(Third Embodiment)

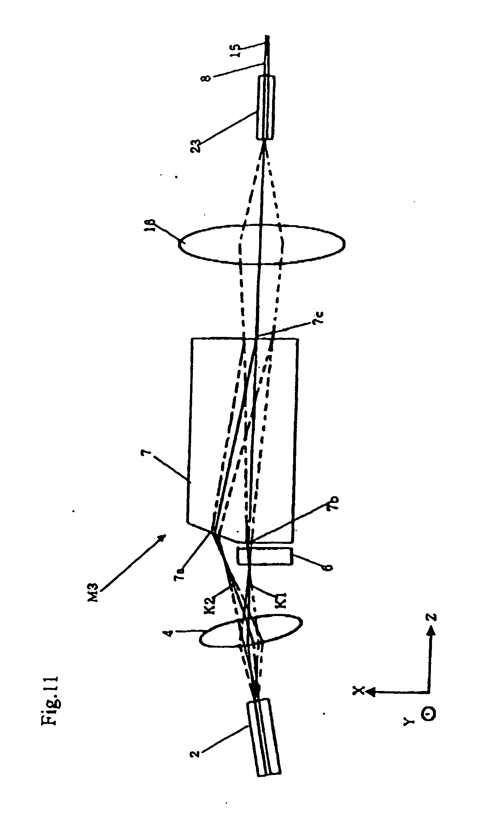

FIG 11 is an explanatory diagram schematically showing a configuration of a semiconductor laser module M3 in accordance with a third embodiment of the present invention. As shown in FIG 11, according to the third embodiment, the semiconductor laser device 2 and the first lens 4 are disposed with tilts at predetermined angles to the axial-line direction so that the first laser beam K1, after traveling through a first lens 4, travels as the normal ray in the axial-line direction of the optical fiber 8. Other than this point, this embodiment is substantially the same as the semiconductor laser module in the first embodiment.

According to the third embodiment, the first laser beam K1 travels as the normal ray in the axial-line direction of the optical fiber 8, and hence there is no necessity of providing the prism 5 between the half-wave plate 6 and the first lens 4, thereby making it possible to simplify the configuration. Further, only one side of the PBC 7 may be polished, and hence the polishing can be more simplified than in the second embodiment.

Moreover, the length of the semiconductor laser module M3 in the optical-axis direction can be reduced, making the optical output less susceptible to the warp of the package that arises in the high-temperature environment.

Note that the half-wave plate 6 and the PBC 7, which are fixed to the same holder member 14, may be structured as a polarization synthesizing module in order to facilitate the angular adjustment about the central axis also in the third embodiment.

Each of the semiconductor laser modules M1 to M3 in the first through third embodiments discussed above is capable of emitting the laser beams with high output, small degree of polarization and stabilized wavelength, and can be therefore used as the pumping light source for the erbium-doped optical amplifier or the Raman amplifier.

(Fourth Embodiment)

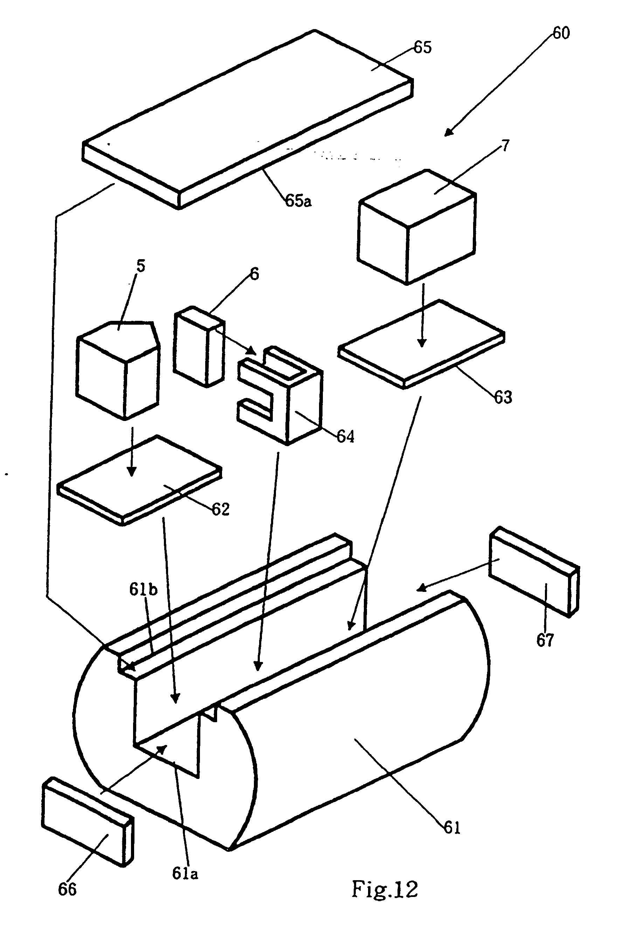

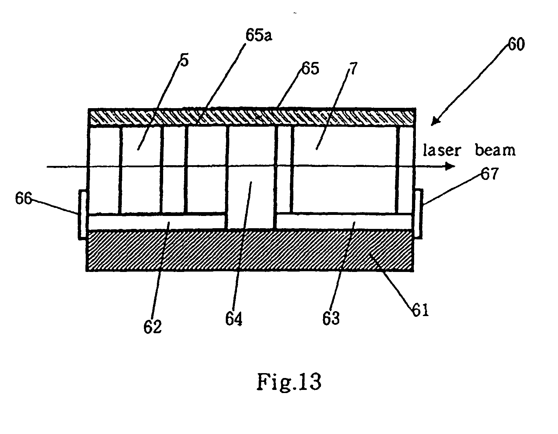

FIG 12 is a fragmentary perspective view showing a polarization synthesizing module 60 in accordance with a fourth embodiment of the present invention, used for a semiconductor laser module in the present invention, which depicts another example of the polarization synthesizing module 59 shown in FIG 4. FIG 13 is a side sectional view showing the polarization synthesizing module 60 shown in FIG 12. Note that, the same members as those in the polarization synthesizing module 59 are marked with the same symbols, and their repetitive explanations are omitted.

As shown in FIGS. 12 and 13, the polarization synthesizing module 60 in the fourth embodiment includes a holder member 61 formed with a groove 61a (an accommodation space) extending in the longitudinal direction, first and second adjustment sheets 62, 63 so disposed as to be fitted into the groove 61a of the holder member 61, the prism 5 disposed on the first adjustment sheet 62, the PBC 7 disposed on the second adjustment sheet 63, a half-wave plate holder 64 so disposed as to be fitted into the groove 61a of the holder member 61, the half-wave plate 6 held by the half-wave plate holder 64, and a plate-like top cover 65 fixedly inset in a stepped portion 61b formed on an aperture side of the groove 61a of the holder member 61.

The holder member 61, the half-wave plate holder 64 and the top cover 65 are made of a material (e.g., Fe-Ni-Co alloy (Kovar)) that can be YAG-laser-welded.

An upper portion of the half-wave plate 6 is metalized, and an upper portion of the half-wave plate holder 64 is gold-plated. The upper portion of the half-wave plate 6 is fixed by soldering to the upper portion of the half-wave plate holder 64.

The first and second adjustment sheets 62, 63 are formed of a material deformable enough to facilitate positioning of the prism 5 and the PBC 7 as well. The first and second adjustment sheets 62, 63 may be composed of a flexible member such as a soft metal (In, and so on) or a solder sheet (Sn-Pb, and so forth), or of a resilient member such as a resin.

The polarization synthesizing module 60 is also fitted with first and second stoppers 66, 67 fixed by the YAG laser welding to both side edges of the groove 61a of the holder member 61. As shown in FIG 13, the first stopper 66 and the half-wave plate holder 64 hold the first adjustment sheet 62 sandwiched in therebetween and thus function as a slide stopper for the first adjustment sheet 62. Further, the second stopper 67 and the half-wave plate holder 64 hold the second adjustment sheet 63 sandwiched in therebetween and thus function as a slide stopper against the second adjustment sheet 63.

Note that the first and second stoppers 66, 67 may be formed beforehand integrally with the holder member 61.

Further, note that the first and second stoppers 66, 67 may be formed of transparent materials such as glass, resin. And the first and second stoppers 66, 67 may be lens, prism, PBC 7, or half wave plate.

Next, a method of assembling the polarization synthesizing module 60 in the fourth embodiment will be explained. At first, the first and second stoppers 66, 67 are fixed by YAG laser welding to both of the side edges of the groove 61 a of the holder member 61.

Subsequently, the half-wave plate 6 is secured by soldering to the half-wave plate holder 64.

Then, the half-wave plate holder 64 holding the half-wave plate 6 is fixed by YAG laser welding to the groove 61a of the holder member 61. On this occasion, the half-wave plate holder 64 is positioned so that the first and second adjustment sheets 62, 63 are respectively fitted in between the first and second stoppers 62, 63 and the half-wave plate holder 64.

Next, the first adjustment sheet 62 is so disposed as to be fitted into the groove 61 a of the holder member 61 between the first stopper 66 and the half-wave plate holder 64. Further, the second adjustment sheet 63 is so disposed as to be fitted into the groove 61a of the holder member 61 between the second stopper 67 and the half-wave plate holder 64.

Subsequently, the prism 5 is placed on the first adjustment sheet 62, and the PBC 7 is placed on the second adjustment sheet 63.

Then, the top cover 65 is set in the stepped portion 61b formed on the aperture side of the groove 61a of the holder member 61. The surfaces of the prism 5 and the PBC 7 are brought into contact with and pressed against an undersurface 65a of the top cover 65. The first and second adjustment sheets 62, 63 are thereby deformed, and the prism 5 and the PBC 7 are positioned in desired positions.

Finally, the top cover 65 is fixed by YAG laser welding to the holder member 61.

In this polarization synthesizing module 60, the top surfaces of the prism 5 and the PBC 7 are brought into contact with and pressed against the undersurface 65a of the top cover 65 and positioned with the aid of the deformations of the first and second adjustment sheets 62, 63. The undersurface 65a of the top cover 65 is formed flat with a higher working precision than the surface of the groove 61a. Accordingly, the light incident surfaces of the prism 5 and of the PBC 7, the top surface of which have been brought into contact with the undersurface 65a of the top cover 65, are positioned precisely perpendicular with respect to the undersurface 65a of the top cover 65, whereby a rotational direction θ about the optical axis can be positioned with high accuracy.

Considering from this point, it is feasible that the working precision of the undersurface 65a of the top cover 65 where the topsurface of the prism 5 and PBC are brought into contact, may fulfil at least one of the conditions below of the planar roughness;

maximum height, Rmax =$\leq$ 10 $\mu$m,

center-line-average-roughness, Ra =$\leq$ 5 $\mu$m,

average roughness measured at 10 points, Ra =$\leq$ 10 $\mu$m.

Note that the first and second adjustment sheets 62, 63 can be integrated to one sheet.

Further, note that the prism 5 and the PBC 7 may be gold-plated and fixed by soldering directly to the groove 61a of the holder member 61. In this case, the first and second adjustment sheets 62, 63 are not required, however, it is preferable that the working surface of the groove 61a be formed accurately.

(Fifth Embodiment)

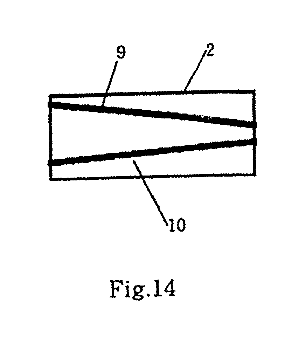

The first and second stripes 9, 10 of the semiconductor laser device 2 described above are formed to extend in parallel to each other in the longitudinal direction. The first and second stripes 9, 10 may, however, be formed to be inclined to each other as shown in FIG. 14. Referring to FIG 14, the laser beams are emitted toward the right side, and the space between the stripes 9 and 10 becomes narrower as it gets closer to the right side edge. In this case, the two first and second laser beams K1, K2 emitted from the two stripes 9, 10 intersect each other at a comparatively short distance away from the semiconductor laser device 2 and thereby decreases a propagation distance L (see FIG.2) which is needed for the first and second laser beams K1 and K2 that have traveled though the first lens 4 to split enough for a half wave plate 6 to be able to be inserted only on the beam path of K1 (namely, for a distance D' in FIG.2 to take a sufficiently large value), and hence the length of the semiconductor laser module M1 in the optical-axis direction can be reduced.

Note that the propagation distance L can be likewise reduced even when emitting the laser beams in the leftward direction.

(Sixth Embodiment)

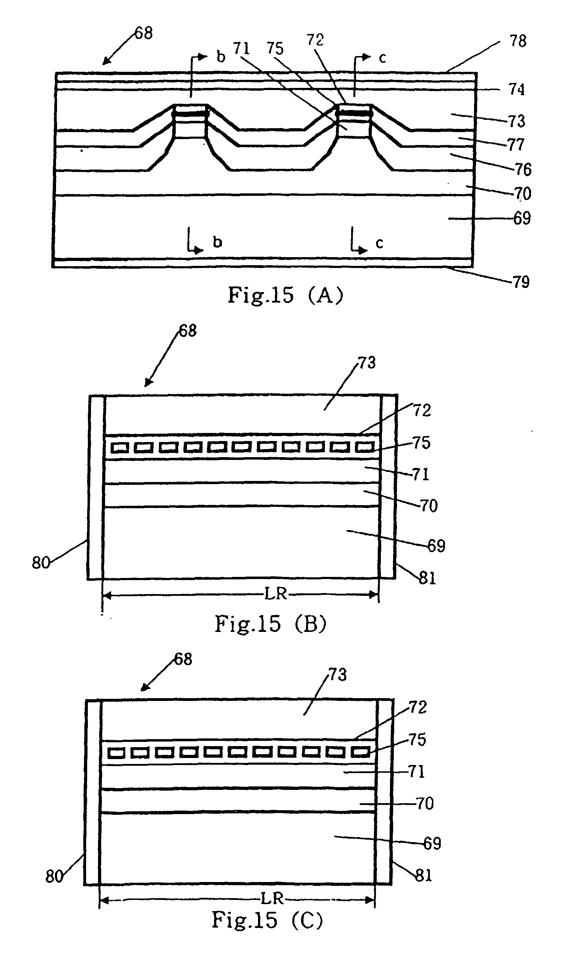

FIGS. 15(A) to 15(C) show a semiconductor laser device 68 in accordance with a sixth embodiment used for the semiconductor laser module in accordance with the embodiments of the present invention and having a different configuration from the semiconductor laser device 2 shown in FIGS. 8(A) to 8(C). FIGS. 15(B) and 15(C) are sectional views taken along the line b-b and the line c-c in FIG. 15(A), respectively.

As shown in FIGS. 15(A) through 15(C), the semiconductor laser device 68 in the sixth embodiment has a structure in which an n-InP buffer layer 70 serving both as a buffer layer and a lower clad layer as well, an active layer 71 comprising a GRIN-SCH-MQW (Graded Index -Separate Confinement Heterostructure multi quantum well), a p-InP clad layer 72, a p-InP buried layer 73 and an GaInAsP cap layer 74, are laminated sequentially on a surface (100) of an n-InP substrate 69.

Within each of the p-InP upper clad layer 72 of the two stripes, p-InGaAs diffraction gratings 75 each having a thickness on the order of 20 nm are formed periodically at a pitch of approximately 230 nm. The diffraction gratings 75 serve to select a center wavelength of the laser beams to a predetermined wavelength, e.g. in the 1480nm band. Upper portions of the p-InP upper clad layer 72 containing the diffraction grating 75, the GRIN-SCH-MQW active layer 71 and the n-InP buffer layer 70, are worked in a mesa stripe. Both sides of the mesa strip are embedded in a p-InP layer 76 and an n-InP layer 77 that are formed as current blocking layers. Further, a p-type electrode 78 is formed on an upper surface of the GaInAsP cap layer 74, and an n-type electrode 79 is formed on an undersurface of the n-InP substrate 69.

A first reflection layer 80 having a reflectance as high as 80% or greater is formed on one edge surface of the semiconductor laser device 68 in the longitudinal direction. A second reflection layer 81 having a reflectance as low as 5% or less is formed on the other edge surface thereof. The beams generated within the GRIN-SCH-MQW active layer 71 of an optical resonator formed between the first and second reflection layers 80, 81, are reflected at the first reflection layer 80 and exit as laser beams via the second reflection layer 81.

The semiconductor laser device 68, if used as a pumping light source for, e.g., the Raman amplifier, has its oscillation wavelength $\lambda_0$ in the range of 1300 to 1550 nm and a cavity length $L_R$ set from 800$\mu$m to 3200$\mu$m.

Note that, a mode spacing $\Delta\lambda$ of the longitudinal modes generated by the resonator of the semiconductor laser device is generally expressed by the following formula.

Namely;

$$\Delta\lambda=\lambda_0{}^2 / (2 \cdot n \cdot L_R)$$

Herein, if the oscillation wavelength $\lambda_0$ is set to 1480 $\mu$m and an equivalent refractive index n is set to 3.5, the longitudinal mode spacing $\Delta\lambda$ is approximately 0.39 nm for the cavity length $L_R$ of 800$\mu$m and approximately 0.1 nm for the cavity length of 3200$\mu$m. That is, as the cavity length is set larger, the longitudinal mode spacing $\Delta\lambda$ becomes narrower, which means generally that the selection condition for single longitudinal mode oscillation gets strict as the cavity length is increased.

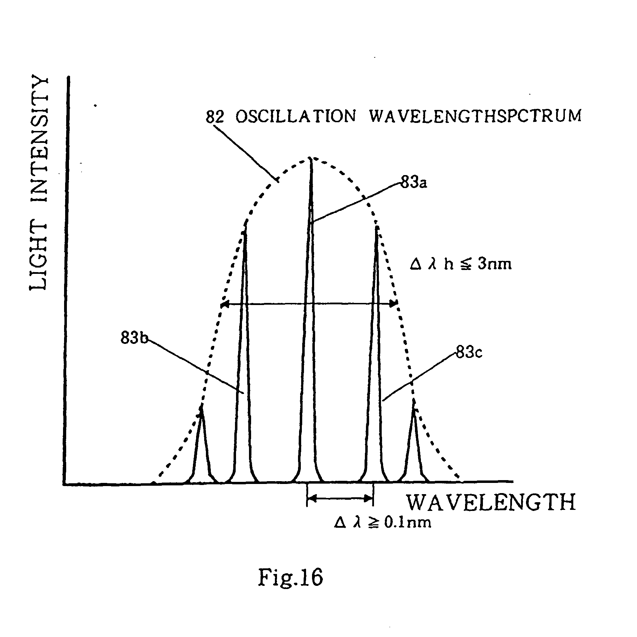

The diffraction grating 75 selects the longitudinal mode with a Bragg wavelength thereof. A wavelength selecting characteristic of this diffraction grating 75 is given as an oscillation spectrum 82 shown in FIG 16. As shown in FIG. 16, a contrivance in accordance with the sixth embodiment is that a plurality of longitudinal modes are oscillating within the FWHM $\Delta\lambda_h$ of the oscillation spectrum of the semiconductor laser device with the diffraction grating 75. Note that the conventional semiconductor laser with a wavelength selective element such as DFB aimed to oscillate in a single longitudinal mode and therefore the cavity length of 800$\mu$m or larger had not been routinely adopted by those skilled in the art because of its narrower longitudinal mode spacing and lower mode selectivity. The semiconductor laser device 68 in the sixth embodiment, however, with the cavity length $L_R$ positively set to 800$\mu$m or larger, emits the laser beams with a plurality of oscillation longitudinal modes contained within the FWHM $\Delta\lambda_h$ of the oscillation spectrum. Referring to FIG. 16, the FWHM $\Delta\lambda_h$ of the oscillation spectrum contains three oscillation longitudinal modes 83a to 83c.

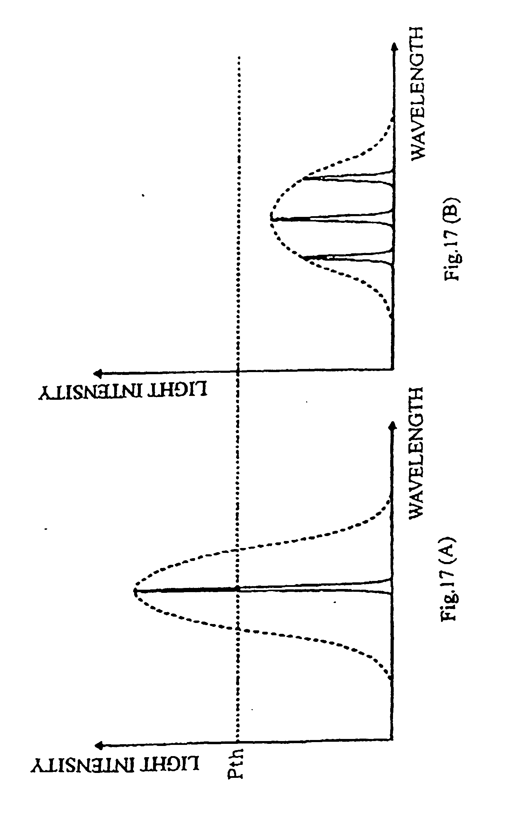

Using the laser beams oscillating in a plurality of longitudinal modes enables to obtain a laser output with the peak intensity of each longitudinal mode more restrained than using the laser beams oscillating in a single longitudinal mode that emit the same intensity of the laser light in total. For example, the semiconductor laser device 68 exemplified in the sixth embodiment has a mode profile as shown in FIG 17(B) and is capable of obtaining a high laser output with a low peak intensity of each longitudinal mode. By contrast, FIG. 17 (A) shows a mode profile of the single longitudinal mode oscillations having a higher peak intensity in the case of obtaining the same laser output in total.

The oscillation in a plurality of longitudinal modes is preferred especially in case where the semiconductor laser device is used as a high-powered pumping light source for Raman amplifier, since the semiconductor laser device can operate at high output without the intensity of each of the longitudinal modes exceeding the threshold Pth above which the stimulated Brillouin scattering can occur, as shown in FIG.17(B), which may be a cause of noise in Raman amplification. Consequently, a high Raman gain can be acquired by using the semiconductor laser device as a pumping light source without no significant increase in noise.

Further, as shown in FIG 16, the wavelength spacing (mode spacing) $\Delta\lambda$ between the oscillation longitudinal modes 83a to 83c is preferably set to 0.1 nm or larger, because such a longitudinal mode spacing is effective for mitigating the stimulated Brillouin scattering that may occur for high-powered lasers. Note that the cavity length $L_R$ of 3200$\mu$m or shorter gives $\Delta\lambda$ of 0.1nm or larger of a semiconductor laser device oscillating at 1480nm.

Furthermore, in Raman amplification, the Raman gain is dependent on the polarization of the signal light (i.e. the amplification takes place when the polarization plane of the signal light and of the pumping light coincide). Therefore, the pumping light is preferred to be depolarized in order to obviate the problem of gain fluctuation associated with the random nature of the polarization of the signal light.

The semiconductor laser module according to the first through sixth embodiments of the present invention emits a polarization-multiplexed laser light with lower DOP than laser light from a single stripe, and therefore is suitable for use as a pumping light source in Raman amplifiers. In case, however, that DOP is not sufficiently reduced, a further measure for depolarization might be employed.

For that purpose, the depolarization can be done using a length of polarization maintaining fiber through which the pumping light from a semiconductor laser device propagates. And the more the number of longitudinal modes is, the shorter a necessary length of the polarization maintaining fiber becomes, because the coherent length of the laser light decreases as the number of longitudinal modes increases.

In this regard, the number of longitudinal modes contained within the FWHM $\Delta\lambda_h$ of the oscillation spectrum is preferably three or more. Particularly when there are four or five oscillation longitudinal modes, the necessary length of the polarization maintaining fiber abruptly decreases. Accordingly, the length of the polarization maintaining fiber used for depolarizing can be reduced by including three or more, and more preferably four or more longitudinal modes within the FWHM $\Delta\lambda_h$ of the oscillation spectrum, thereby simplifying the amplifier and reducing the cost thereof.

Herein, if the oscillation spectral width (the FWHM of the oscillation spectrum) is too large, a multiplexing loss by a wavelength synthesizing coupler increases, and a fluctuation of longitudinal modes within the spectral width might create noise or fluctuation of gain. Therefore, the FWHM $\lambda_h$ of the oscillation spectrum 82 is preferably set to 3 nm or less and still preferably to 2 nm or less.

Moreover, in the semiconductor laser module with the fiber Bragg grating (FBG), a resonance between the FBG and rear edge surface 2b of the semiconductor laser device, creates noise peaks that appear periodically on the frequency axis of the RIN (relative intensity noise) profile of the pumping light, adding noise to amplified signal in Raman amplifiers.

By contrast, the semiconductor laser module using the semiconductor laser device 68 with a diffraction grating integrated in the stripes emits a wavelength-stabilized laser light with no such noise peak, and therefore is suitable for use as a pumping light source of Raman amplifier.

Further, the semiconductor laser module using the FBG includes the mechanical coupling within the resonator (i.e. YAG welding spots connecting a flange 1a and a ferrule 23 holding an optical fiber 8 with FBG), and consequently there arises a case in which the oscillation characteristic of the laser changes due to the vibrations or the change in temperature. By contrast, the semiconductor laser device 68 in the sixth embodiment requires no mechanical coupling to form a resonator, and is free from change in the laser oscillation characteristic due to the mechanical vibrations or the change in temperature, and is capable of obtaining the stable optical output.

According to the sixth embodiment, since the semiconductor laser device 68 emits laser beams with wavelength between 1300 to 1500nm selected by the diffraction gratings 75, and since it is equipped with a cavity of 800 to 3200$\mu$m in length $L_R$, it emits laser beams with a plurality of longitudinal modes, preferably four or more longitudinal modes, oscillated within the FWHM $\Delta\lambda_h$ of the oscillation spectrum. As a result, the stable and high Raman gain can be obtained without the occurrence of the stimulated Brillouin scattering when used as the pumping light source for the Raman amplifier.

Furthermore, since the semiconductor laser device 68 is equipped with diffraction gratings 75 integrated in the stripes, it is free from instability associated with the vibration or the change in temperature that otherwise might have affected the coupling to the optical fiber with FBG which was external to the semiconductor laser device.

(Seventh Embodiment)

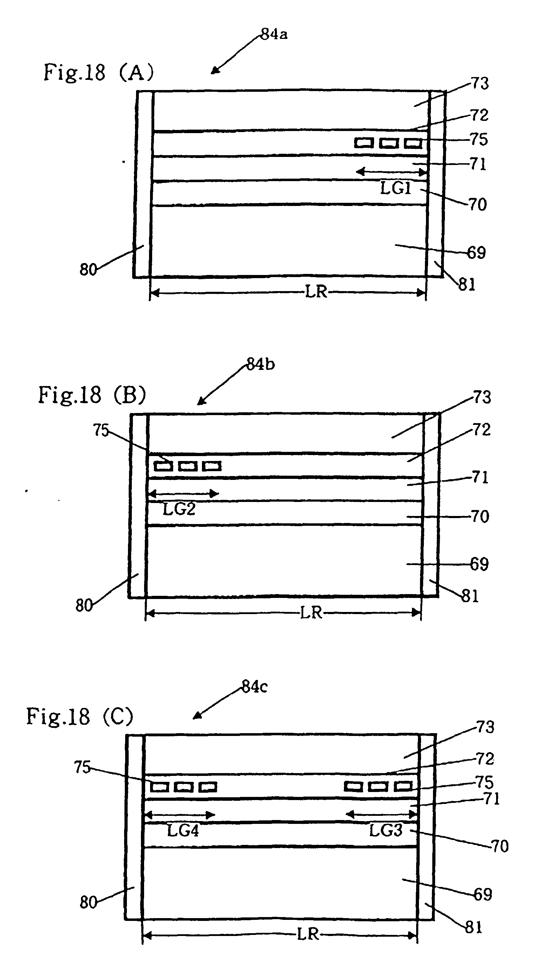

FIGS. 18(A) to 18(C) are vertical sectional views each showing a configuration of the semiconductor laser device in the longitudinal direction according to a seventh embodiment.

In the sixth embodiment discussed above, there are provided a plurality of longitudinal modes within FWHM $\Delta\lambda_h$ of the oscillation spectrum 82 by increasing the cavity length $L_R$. In contrast with this contrivance, according to the seventh embodiment, the FWHM $\Delta\lambda_h$ of the oscillation spectrum 82 is changed by varying a grating length LG of the diffraction grating 75 or a coupling coefficient, whereby the number of longitudinal modes within FWHM $\Delta\lambda_h$ is increased.

As shown in FIG. 18(A), a semiconductor laser device 84a is different from the semiconductor laser device 68 in the sixth embodiment in the layout of the diffraction gratings 75 and in the reflectance of the second reflection layer 81. The configurations of other components are substantially the same as those of the semiconductor laser device 68, and the same components are marked with the same reference numerals, of which the repetitive explanations are omitted.

The diffraction gratings 75 are formed over a predetermined length LG1 ,which is shorter than the entire cavity length $L_R$, as opposed to the case shown in FIG.15(B), extending from the second reflection layer 81 having a reflectance as low as 2% or less, preferably 1% or less, more preferably 0.2% or less toward the first reflection layer 80 having a reflectance as high as 80% or greater, but not formed in the p-InP clad layer 72 out of the predetermined length LG1.

Further, FIG. 18(B) is a vertical sectional view showing in the longitudinal direction a configuration of a semiconductor laser device 84b defined as a modified example of the seventh embodiment. This semiconductor laser device 84b has the diffraction gratings 75 provided on the side of the first reflection layer 80, in which the reflectance of the first reflection layer 80 is set to be low. Namely, the diffraction gratings 75 are provided over a predetermined length LG2, which is shorter than the entire cavity length $L_R$, as opposed to the case shown in FIG.15(B), extending from the first reflection layer 80 having a reflectance as low as 0.1 to 2% toward the second reflection layer 81 having a reflectance as low as 1 to 5%, but are not formed in the upper p-InP clad layer 72 out of the predetermined length LG2.

Moreover, FIG 18(C) is a vertical sectional view showing in the longitudinal direction a configuration of a semiconductor laser device 84c defined as another modified example of the seventh embodiment. This semiconductor laser device 84c simultaneously adopts the layouts of the diffraction gratings 75 shown in FIG. 18(A) and of the diffraction gratings 75 shown in FIG 18(B).

Namely, the semiconductor laser device 84c has the diffraction gratings 75 formed over a predetermined length LG3, which is shorter than the entire cavity length $L_R$, as opposed to the case shown in FIG.15(B), extending from the second reflection layer 81 having a reflectance as low as 2% or less toward the first reflection layer 80 having a reflectance as low as 2% or less, and the diffraction gratings 75 formed over a predetermined length LG4, which is shorter than the entire cavity length $L_R$, as opposed to the case shown in fig.15(B), extending from the first reflection layer 80 toward the second reflection layer 81.

The FWHM $\Delta\lambda_h$ of the oscillation spectrum 82 shown in FIG. 16 can be varied by changing the predetermined lengths of the diffraction gratings 75 shown in FIG 18 while the mode spacing $\Delta\lambda$ of the oscillation longitudinal modes is kept constant.

That is, it is effective to reduce the length of the diffraction gratings 75 for increasing the FWHM $\Delta\lambda_h$ of the

oscillation spectrum 82. Hence, as shown in the seventh embodiment, the diffraction gratings 75 are not formed over the entire length of the resonator (GRIN-SCH-MQW active layer 71) but are formed on a segment of this cavity length.

In this case, a laser oscillation characteristics might not suffice unless the reciprocating light meets the phase matching condition defined by the resonator cavity, the deviation from the phase matching condition existing depending on the positions of the diffraction gratings 75 within the resonator. Hence, as shown in FIG. 18(A), if the diffraction gratings 75 are formed extending from the second reflection layer 81 up to a point halfway along the resonator toward the first reflection layer 80, the second reflection layer 81 preferably has the reflectance of as low as 2% or less, and the first reflecting layer 80 preferably has the reflectance of as high as 80% or greater. Further, as shown in FIG.18 (B), if the diffraction gratings 75 are formed extending from the first reflection layer 80 up to a point halfway along the resonator toward the second reflection layer 81, the first reflection layer 80 preferably has the reflectance of as low as 2% or less, and the second reflecting layer 81 preferably has the reflectance of as low as 1 to 5%. Moreover, as shown in FIG. 18 (C), if the diffraction gratings 75 are formed on both sides of the second and first reflection layers 81 and 80, both of the second and first reflection layers 81, 80 preferably have low reflectances of 2% or less.

Further, as shown in FIG 18(A), when the diffraction gratings 75 are formed on the side of the second reflection layer 81, it is preferable that the reflectance of the diffraction grating 75 itself be set comparatively low. As shown in FIG 18(B), when the diffraction gratings 75 are formed on the side of the first reflection layer 80, it is preferable that the reflectance of the diffraction grating 75 itself be set comparatively high. Moreover, as shown in FIG. 18(C), when the diffraction gratings 75 are formed on both sides of the first and second reflection layers 80, 81, the reflectance of the diffraction grating 75 itself provided on one side is preferably set comparatively low, and the reflectance of the diffraction grating 75 itself formed on the other side is preferably set comparatively high. With the settings described above, the influence of the Fabry Perot resonator formed by the first and second reflection layers 80, 81 can be reduced and the wavelength selection by the diffraction gratings 75 is effected.

To be more specific, the semiconductor laser device shown in FIG 18(A) may be 1300$\mu$m in the cavity length $L_R$, 50$\mu$m in the length (LG1) of the diffraction gratings 75, and 0.125 in the product $K*L_G$ of the coupling coefficient K and the length of grating $L_G$. The diffraction gratings 75 described above can generate approximately 2nm of the FWHM $\Delta\lambda_h$ of the oscillation spectrum 82 which contains three to eight oscillation longitudinal modes.

Further, referring to FIGS. 18(A) through 18(C), the diffraction gratings 75 are provided on either side of the second reflection layer 81 or the first reflection layer 80, or on the both sides of the second and first reflection layers 81, 80. The diffraction gratings 75 may not be limited to the above layouts, but may be formed on any segment of the cavity length along the GRIN-SCH-MQW active layer 71.

According to the seventh embodiment, the length of the diffraction gratings 75 is set segmental to the cavity length $L_R$, and the grating length LG and the coupling coefficient $KL_G$ of the diffraction gratings 75 are properly varied, thereby obtaining the desired FWHM$\Delta\lambda_h$ of the oscillation spectrum 82. Then, the laser beams having a plurality of oscillation longitudinal modes within this FWHM $\Delta\lambda_h$ can be obtained, and the semiconductor laser device exhibiting the same advantage as the sixth embodiment can be realized.

(Eighth Embodiment)

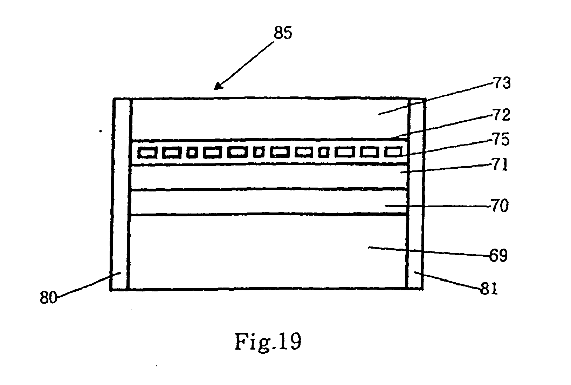

FIG 19 is a vertical sectional view showing in the longitudinal direction a configuration of the semiconductor laser device in accordance with an eighth embodiment of the present invention.

The grating period of the diffraction gratings 75 is fixed in the sixth and seventh embodiments discussed above. In this eighth embodiment, however, the diffraction grating is chirped to have a periodical change in the grating period , thereby causing a fluctuation in the wavelength selection characteristic of the diffraction gratings 75, which leads to the broadening of the FWHM $\Delta\lambda_h$ of the oscillation spectrum 82, and increase in the number of oscillating longitudinal modes within the FWHM $\Delta\lambda_h$.

As shown in FIG. 19, the semiconductor laser device 85 has a chirped gratings 75 of which the grating period is periodically changed. The configurations of other components are the same as those of the semiconductor laser device 68 in the sixth embodiment, and the same components are marked with the same symbols, of which the repetitive explanations are omitted.

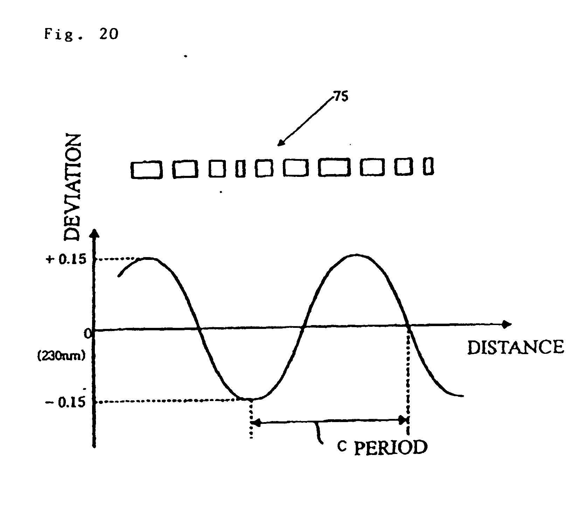

FIG 20 is a graph showing the periodic change in the grating period of the diffraction gratings 75. As shown in FIG 20, the diffraction gratings 75 have an average period of 230 nm with a periodic fluctuation (deviation) of the magnitude of $\pm$0.15 nm that repeats with a period C. This periodic fluctuation generates a FWHM of approximately 2 nm for the reflection band of the diffraction grating 75, and about three to six oscillation longitudinal modes can be thereby present within the FWHM $\Delta\lambda_h$ of the oscillation spectrum 82.

In the eighth embodiment discussed above, the chirped gratings are formed over an entire cavity length $L_R$. The chirped diffraction gratings 75 may not be limited to the above layouts, but may be disposed to a segment of the cavity length $L_R$. Namely, the chirped gratings exemplified in the eighth embodiment discussed above may be applied to the seventh embodiment.

Further, the eighth embodiment involves the use of the chirped gratings with the fixed period C of the fluctuation. The period of fluctuation is not, however, limited to this fixed period C but may be changed at random between a period Λ1 (230 nm + 0.15 nm) and a period Λ2 (230 nm - 0.15 nm).

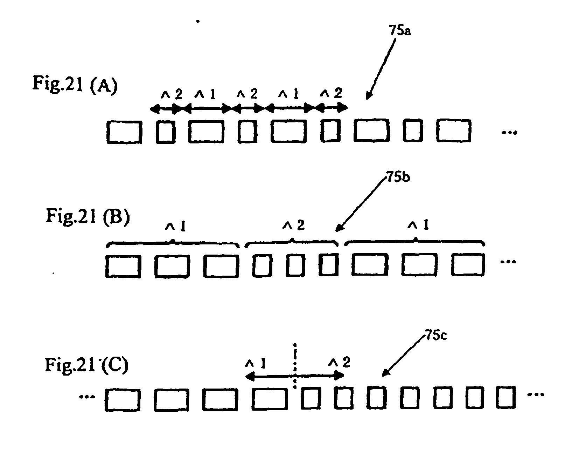

Moreover, as shown in FIG. 21(A), the diffraction grating 75a may be equipped with pairs of period Λ1 and Λ2 , each period alternating one by one to give fluctuations in its period. Further, as shown in FIG 21(B), the diffraction gratings 75b may be equiped with pairs of a group of a plurality of period Λ1 and a group of a plurality of period Λ2, each group alternating one by one to give fluctuations in its period. Still further, as shown in FIG. 21(C),_the diffraction grating 75c may be constituted of a plurality of period Λ1 and a plurality of period Λ2, each period occurring consecutively to give fluctuation in its period. Moreover, the diffraction gratings may be laid out such that a plurality of discrete values interpolate between Λ1 and Λ2.

In the eighth embodiment, the diffraction gratings 75 formed in the semiconductor laser device are chirped so that it gives the period fluctuation of the magnitude of ±0.05 to 0.2 nm around the average. The FWHM of the reflection band of the diffraction grating 75 and the resulting FWHM $\Delta\lambda_h$ of the oscillation spectrum is thereby set to a desired_ value so that the laser beams with a plurality of oscillation longitudinal modes contained within the FWHM $\Delta\lambda_h$ are outputted. It is therefore possible to realize the semiconductor laser device having the same advantage as the sixth or seventh embodiment.

(Ninth Embodiment)

According to the semiconductor laser devices in the sixth through eighth embodiments, the wavelengths selected by the diffraction gratings 75 formed in the two stripes are substantially the same. By contrast, according to the semiconductor laser device in accordance with a ninth embodiment of the present invention, the wavelengths selected by the diffraction gratings 75 formed in the two stripes are different.

If the wavelengths selected by the diffraction gratings 75 formed in the two stripes are slightly different (by 0.1 nm or larger but less than 3 nm, for example, approximately 0.5 nm), the oscillation spectrums from the two stripes overlap to contain a larger number of longitudinal modes within the FWHM, which is suitable for use in Raman amplification in terms of decreasing DOP.

Furthermore, the two stripes can be designed to have diffraction gratings with different wavelengths, each having a wavelength different from the other by on the order of several nanometers to several tens of nanometers (e.g. 3nm or larger). The laser beams emitted from the two stripes of the single semiconductor laser device are wavelength-multiplexed by use of a built-in wavelength synthesizing element provided in a package 1, and thus eliminating the need for an external wavelength-synthesizing couplers that are conventionally used for multiplexing laser lights from a plurality of discrete semiconductor laser modules, leading to downsizing of amplifiers.

In this case, the optical output often needs to be controlled by the respective wavelengths thereof. For this purpose, a separation trench 38 is formed between the two stripes, as shown in FIG 8(C), and the surface of which is covered with an insulation layer 39, whereby the two stripes are electrically separated and can be driven independently.

In the sixth through ninth embodiments, the wavelengths of the laser beams outputted from the semiconductor laser module can be arbitrarily set by forming the two stripes with an arbitrary combination of the diffraction gratings 75.

Note that the half-wavelength plate 6 may not be used if the laser beams emitted from the two stripes, each emitting a laser beam of different wavelength, are wavelength-synthesized without a birefringence material such as rutile, namely if the laser beams are wavelength-synthesized by use of, for example, a prism.

(Tenth Embodiment)

If a polarization-maintaining fiber with FBG is used to receive the two fluxes of laser beams from the double-stripe type semiconductor laser module as exemplified in the first through fifth embodiments, the polarization-maintaining fiber is normally aligned so that the polarizing directions of the two fluxes of laser beams are coincident with polarization-maintaining axes of the polarization-maintaining fiber.

By contrast, the tenth embodiment uses the semiconductor laser device formed with the two stripes containing the diffraction gratings 75 as exemplified in each of the sixth through ninth embodiments and eliminates the need for FBG, wherein the optical coupling may be attained in such a way that the polarization-maintaining axes of the polarization maintaining fiber deviates by 45 degrees from the polarizing direction of each of the two fluxes of laser beams emitted from the semiconductor laser device. This contrivance enables the polarization maintaining fiber to function as a depolarizer which effectively reduces the DOP.

(Eleventh Embodiment)

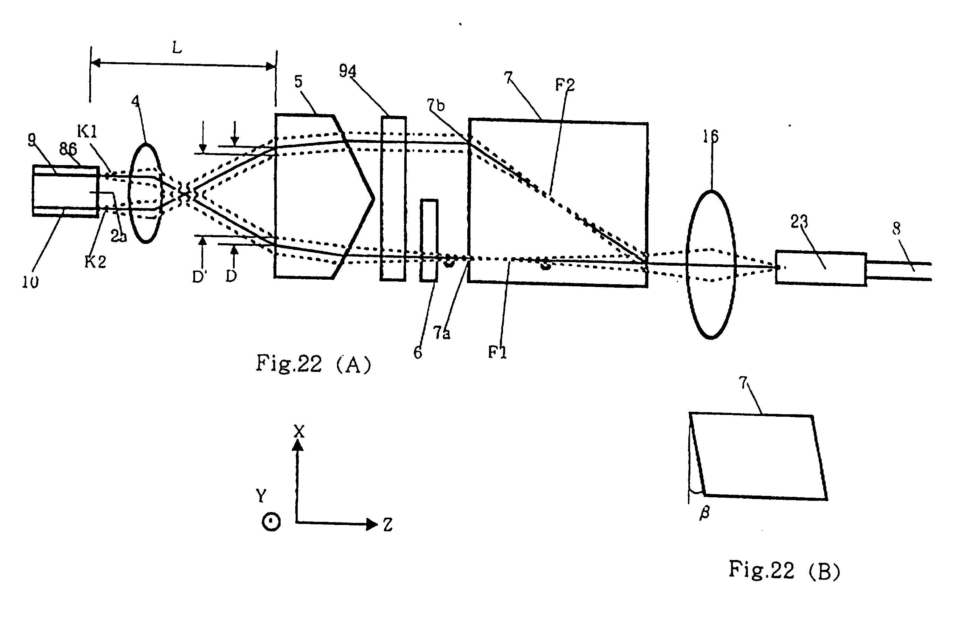

FIG 22(A) is an explanatory diagram schematically showing a configuration of the semiconductor laser module in accordance with an eleventh embodiment of the present invention.

As shown in FIG 22(A), the eleventh embodiment uses one of the semiconductor laser devices as exemplified in each of the sixth through tenth embodiments (which is representatively denoted by the numeral 86) each provided with the diffraction gratings 75 in the two stripes 9, 10, and thus eliminates the need for providing an optical fiber 8 with a beam reflection element 15 such as FBG and so on. Further, an optical isolator 94 is disposed between the first lens 4 and the second lens 16 that transmits the first beam K1 and the second laser beam K2 emitted from the semiconductor laser device 86 only toward the optical fiber 8. Other than this point, this embodiment is substantially the same as the semiconductor laser module in the first embodiment. The optical isolator disposed therebetween enables for the semiconductor laser device 86 to be stabilized of its operation by preventing the reflection from being coupled back to the semiconductor laser device 86. Note that the optical isolator 94 is disposed in a position where the first and second laser beams K1, K2 are parallel, e.g., a position between the prism 5 and the half-wavelength plate 6, whereby one single optical isolator 94 can deal both.

Instead of using an optical isolator 94, the PBC 7 may be inclined so that the laser beams K1, K2 are obliquely incident on an incident surface of the PBC 7 in order to prevent the reflection from coupling back to the semiconductor laser device 86. Note that the half-wave plate 6 and the PBC 7 may be fixed to the same holder member 14 to configure the polarization synthesizing module in order to facilitate the angular adjustment.

Further, as shown in FIG. 22(B), an incident surface of the PBC 7 may be given an inclination of angle $\beta$(e.g., 4 degrees) in the Z-axis direction for preventing the reflection from coupling back to the semiconductor laser device 86.

(Twelfth Embodiment)

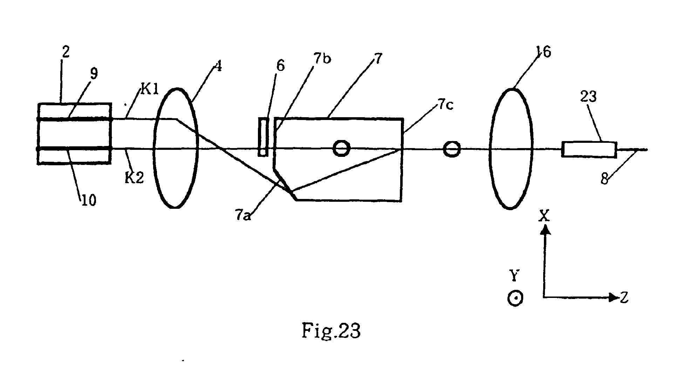

FIGS. 23 is an explanatory diagram schematically showing a configuration of the semiconductor laser module in accordance with a twelfth embodiment of the present invention.

As shown in FIG 23, the twelfth embodiment has such a characteristic configuration that the second laser beams K2 of the first and second laser beams K1, K2 emitted from the semiconductor laser device 2 including the two stripes 9, 10 travels through the central point of the first lens 4 in the axial-line direction of the optical fiber 8.

In the optical synthesizing element 7 (PBC), the input part 7b and the output part 7c for the second laser beam K2 are formed perpendicular to the optical axis of the second laser beam K2, and the input part 7a for the first laser beam K1 is formed with an inclination to these surfaces. Other than this point, this embodiment is substantially the same as the semiconductor laser module in the first embodiment.

According to the twelfth embodiment, since the second laser beam K2 travels through the central point of the first lens 4 in the axial-line direction of the optical fiber 8, and since the first laser beam K1 is deflected by the first lens 4 with a wider divergence from the second laser beam K2, it is possible to eliminate the necessity of providing the prism and to simplify the configuration.

Moreover, since the length of the semiconductor laser module in the optical axial direction can be reduced, the optical output becomes less susceptible to the warp of the package that arises in the high-temperature environment.

Further, since polishing to form the inclined surfaces onto the optical synthesizing element 7 is needed only for the input part 7a, the optical synthesizing element 7 can be obtained by reduced cost.

Note that the half-wavelength plate 6 and the PBC 7 may be fixed to the same holder member 14 to configure the polarization synthesizing module in order to facilitate the angular adjustment about the central axis.

(Thirteenth Embodiment)

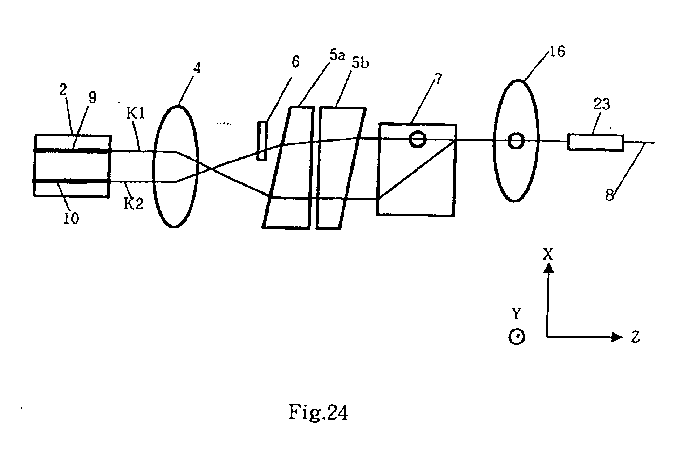

FIG. 24 is an explanatory diagram schematically showing a configuration of the semiconductor laser module in accordance with a thirteenth embodiment of the present invention.

As shown in FIG. 24, the thirteenth embodiment has such a characteristic configuration that a plurality (two pieces, for instance, in FIG 24) of prisms 5a, 5b are disposed in the optical-axis direction. The prisms 5a, 5b have flat input surfaces for inputting the two laser beams K1, K2 and flat output surfaces formed in non-parallel to the input surfaces. Other than this point, this embodiment is substantially the same as the semiconductor laser module in the first embodiment. According to the thirteenth embodiment, the two laser beams K1, K2 can be collimated by the prisms with high accuracy.

Note that in this embodiment, the semiconductor laser device with diffraction gratings 75 each having different wavelength can be employed.

(Fourteenth Embodiment)

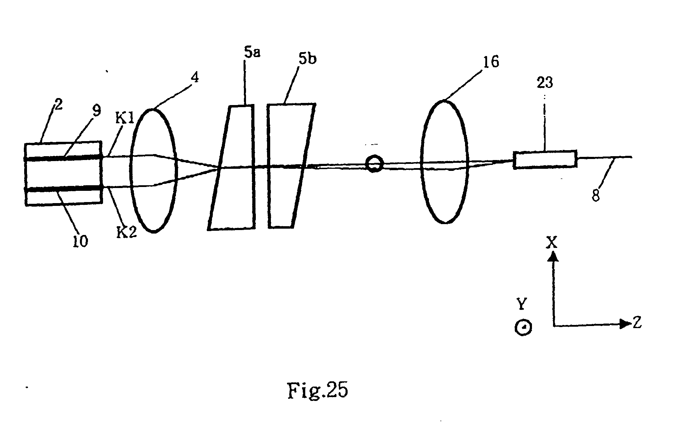

FIG 25 is an explanatory diagram schematically showing a configuration of the semiconductor laser module in accordance with a fourteenth embodiment of the present invention.

As shown in FIG 25, the fourteenth embodiment involves the use of the same prisms 5a, 5b as those in the thirteenth embodiment and has such a characteristic that the incident surface of the prism 5a is disposed in a position where the first and second laser beams K1, K2 penetrating the first lens 4 are substantially overlapping with each other. And further, in this embodiment, the semiconductor laser device 2 is equipped with diffraction gratings 75, each stripe having one of different wavelength each other. According to the fourteenth embodiment, the two laser beams K1, K2 penetrating the prisms 5a, 5b and substantially overlapping with each other are incident upon the condenser lens 16, and therefore it is possible to obtain a more simplified configuration. Note that the prisms 5a, 5b are herein defined as wavelength synthesizing elements.

Further, since the length of the semiconductor laser module in the optical axial direction can be reduced, the optical output becomes less susceptible to the warp of the package that arises in the high-temperature environment.

(Fifteenth Embodiment)

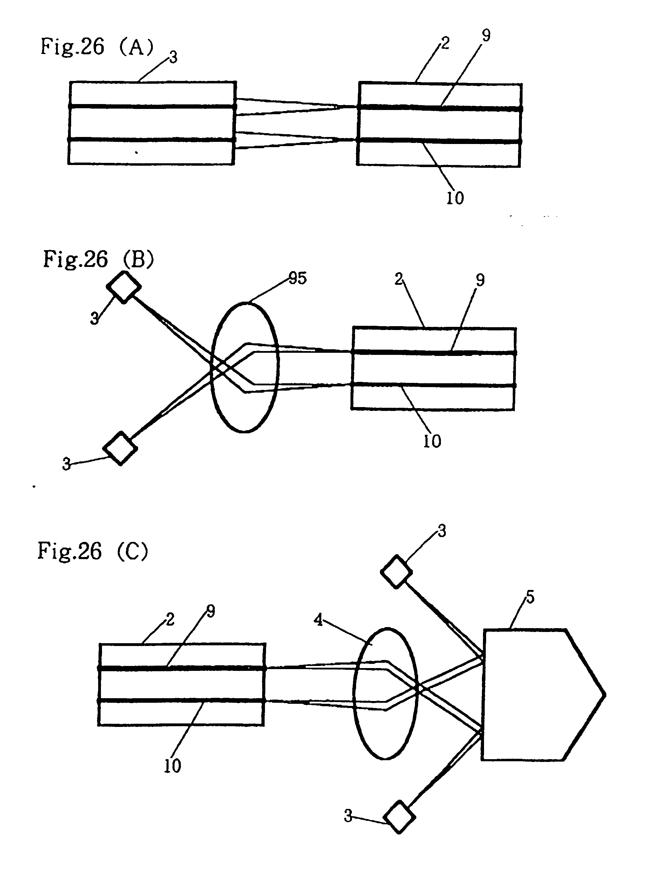

FIGS. 26(A) to 26(C) are explanatory diagrams showing an example of the photo diode (the light receiving element) 3 in accordance with a fifteenth embodiment of the present invention.

The photo diode 3 may be, as shown in FIG. 26(A), a waveguide type light receiving device for receiving the beams emitted from the rear (left side in FIG.26) edge surfaces of the stripes 9, 10 of the semiconductor laser device 2.

Further, a plurality of photo diodes 3 may be, as shown in FIG. 26(B), provided for receiving to monitor the respective beams emitted from the rear edge surfaces of the stripes 9, 10 of the semiconductor laser device 2. In this case, a lens 95 is preferably disposed between the semiconductor laser device 2 and the photo diode 3 for splitting the laser beams emitted from the semiconductor laser device 2 so as to have a divergence therebetween.

Further, the photo diode 3 may receive to monitor the respective beams which are emitted from the front edge surfaces of the stripes 9,10 and reflected by the prism5 as shown in FIG. 26(C).

An APC (auto power control) circuit, for instance, adjust a quantity of the drive current supplied to each of the stripes of the semiconductor laser device 2 based on the result of monitoring by the photo diodes 3, thereby controlling the optical outputs at a constant level.

According to the configuration described above, the APC can be effected on the two stripes independently, and the laser beams K1, K2 can also be kept at an arbitrary light intensity balance.

(Sixteenth Embodiment)

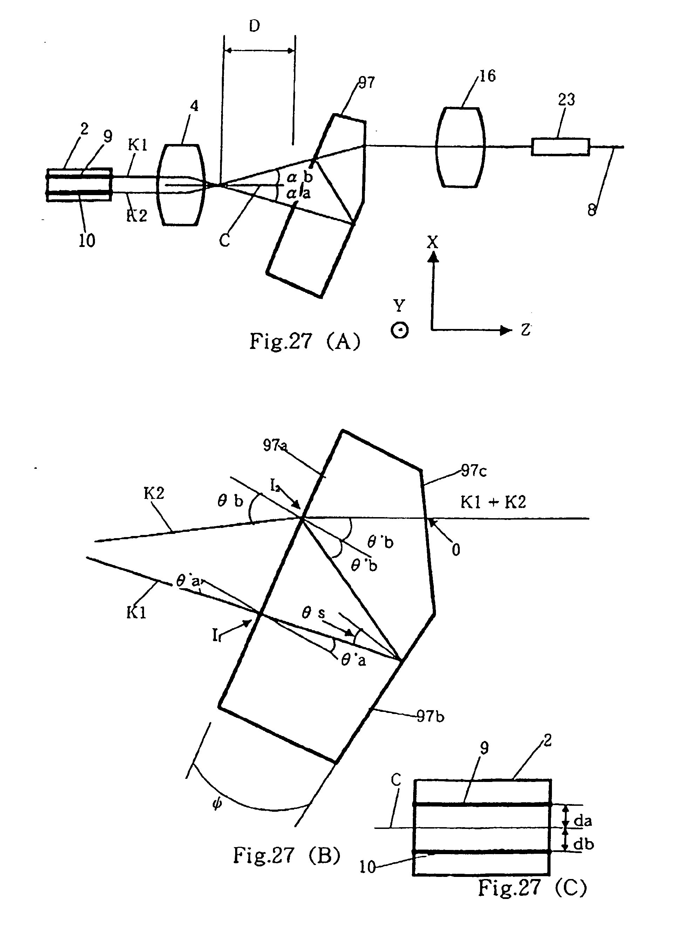

FIGS. 27(A) and 27(B) are explanatory diagrams schematically showing a configuration of the semiconductor laser module in accordance with a sixteenth embodiment of the present invention.

As shown in FIG 27(A), the semiconductor laser module in the sixteenth embodiment includes the semiconductor laser device 2, having the plurality of stripes 9, 10 (two stripes in an example shown in FIG 27) formed with a space therebetween, for emitting a plurality of laser beams K1, K2 from the front edge surfaces thereof. The semiconductor laser module further includes the first lens 4 for converging a plurality of laser beams emitted from the semiconductor laser device each on a different focal point, a prism 97 serving as a beam synthesizing element for synthesizing the plurality of laser beams traveling through the first lens 4, and the optical fiber 8 for receiving the laser beams emerging from the prism 97 and letting the beams travel outside.

The stripes 9, 10 of the semiconductor laser device 2 include the diffraction gratings 75 described above, each stripe emitting laser beam of different wavelength each other.

The sixteenth embodiment uses, as shown in FIG 27(B), a wedge-shaped prism 97. The incident surface of this wedge-shaped prism is formed with a wavelength selection filter 97a composed of, e.g., dielectric multi-layer film that reflects or transmits the incident laser beam depending on the wavelength and the incident angle thereof

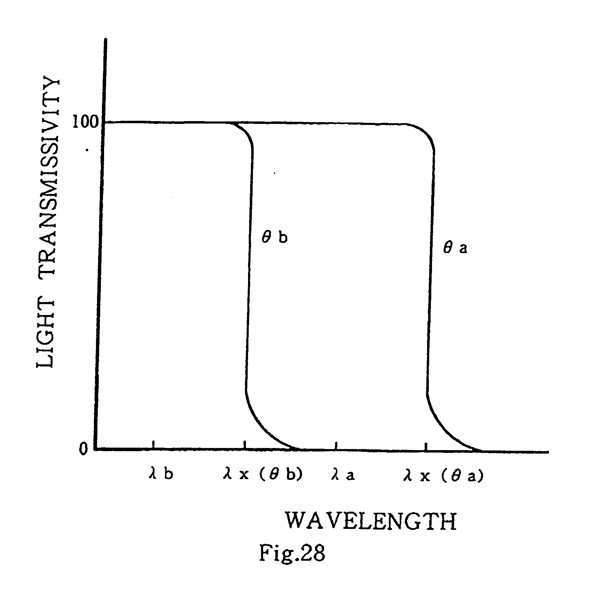

FIG. 28 is a graph showing a beam transmissivity of the wavelength selection filter 97a. As shown in FIG.28, the beam transmissivity depends on an incident angle upon the wavelength selection filter 97a. When the incident angle is $\theta b$, the filter 97a transmits almost 100% of the incident beams of the wavelength $\lambda x(\theta b)$ or less, while reflects almost 100% of the incident beams of the wavelength longer than $\lambda x(\theta b)$. Further, when the incident angle $\theta a$ the filter 97a transmits almost 100% of the incident beams of the wavelength $\lambda x(\theta a)$ or less, while reflects almost 100% of the incident beams of the wavelength longer than $\lambda x(\theta a)$.

Moreover, the exit surface of the wedge-shaped prism 97 is formed with a total reflection layer 97b that reflects the beams irrespective of the wavelengths, and an antireflection layer 97c that prevents the reflection.

In the sixteenth embodiment, the prism 97 is inclined so that the laser beams K1, K2 are incident on the wavelength selection filter 97a at an angle $\theta a$ and $\theta b$, respectively, with the wavelengths of the laser beams K1, K2 being set to $\lambda a$ and $\lambda b$, respectively.

In this case, the first laser beam K1, incident on the first input part $I_1$ of the wavelength selection filter 97a at the angle $\theta a$, propagates at an angle $\theta' a$ through the prism 97 with a refractive index Np. Then, the first laser beam K1 is reflected at an angle θs (θa + wedge angleΨ) from the total reflection layer 97b (the reflection part) and reaches the second input part $I_2$ for the second laser beam K2.

The second laser beam K2, incident on the second input part $I_2$ of the wavelength selection filter 97a at the angle θb, propagates at the angle θ'b through the prism 97 with the refractive index Np. Since the first laser beam K1 is reflected at an angle θ'b (2θs + wedge angle Ψ) from the second input part $I_2$ of the wavelength selection filter 97a, the first and second laser beams K1, K2 are synthesized. The synthesized laser beam (K1 + K2) travels through the output part O formed with the antireflection layer 97c.

The optical module in the sixteenth embodiment is designed based on, e.g., the following numerical values and can be thereby embodied.

(1) The oscillation wavelength of each of the stripes of the semiconductor laser device : λa = 1480 nm, λb = 1460 nm;
(2) The beam spot size (radius) at the light-exit surface (front edge surface) of the semiconductor laser device : wLD = 1.7 μm;
(3) The distance between the first stripe 9 and the optical axis C of the first lens 4 : da = - tanαa · f2 = 19.16 μm;
(4) The distance between the second stripe 10 and the optical axis C of the first lens 4 : db = - tanαb · f2 = -19.16μm
(5) The focal length of the first lens 4 : f2 = 720 μm;
(6) The angle made between the optical axis C of the first lens 4 and the first laser beam K1 αa = (θa - θb)/2 = -1.524°;
(7) The angle made between the optical axis C of the first lens 4 and the second laser beam K2 : αb = (θb -θa)/2 = 1.524°;
(8) The parameter of prism 97 :Ψ(wedge angle) = 1°, Np = 1.5;
(9) The thickness of the prism 97 in the incident position of the first laser beam K1 : t = 1mm;
(10) The angle of incidence and refraction of the laser beams by the prism 97 : θa = 12.050°, θ'a = 8°, θb = 15.098°, θ'b = 10°;
(11) The interval between the incident positions of the first and second laser beams K1, K2 : Δy ≐ 2(tanθa +Ψ)t ≐ 0.462 mm;
(12) The distance along the optical axis from the intersecting position of the two beams to the edge surface of the prism 97 : D ≐ Δy/(θb -θa) = 8.7 mm;
(13) The cut-off wavelengths of the wavelength selection filter 97a : λx(θa) = 1486.5 nm, □λx (θb) = 1470 nm, λx (0) = 1522.6 nm;
(14) The focal length of the second lens 4 : f3 = 2100 μm;
(15) The mode field radius of the optical fiber : wf= 5 μm

Note that the maximum allowable angular tolerance Δθ, which is defined as the width of the intersecting angle θ of the laser beams K1, K2 that have traveled through the first lens 4 at both ends of which the coupling efficiency to the optical fiber decreases by 1dB from maximum, is about 0.013°. For the intersecting angle θ to fall within this range, the respective elements may be manufactured such that the wedge angle of the prism 97 (Ψ) fall within 1 ± 0.003°, the distance between the first stripe 9 or second stripe 10 and the optical axis C of the first lens 4 (da, -db) within 19.16 ± 0.03 μm, and the focal length of the first lens 4 (f2) within 720± 0.7 μm. With such parameters met, the coupling efficiency of each of the stripes 9, 10 to the optical fiber 8 can be set to 80% or greater.

(Seventeenth Embodiment)

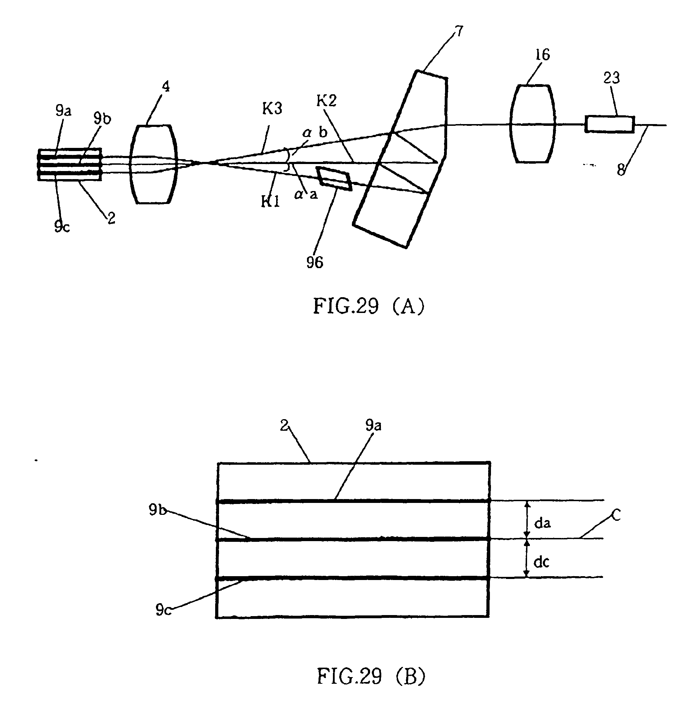

FIGS. 29(A) and 29(B) are explanatory diagrams schematically showing a configuration of the semiconductor laser module in accordance with a seventeenth embodiment of the present invention.

As shown in FIG 29(A), the semiconductor laser module in the seventeenth embodiment includes the semiconductor laser device 2, having the plurality of stripes 9a, 9b, 9c (three stripes in FIG. 29, for instance) formed with a space therebetween, for emitting a plurality of laser beams K1, K2, K3 from the front edge surfaces of the stripes 9a, 9b, 9c. The semiconductor laser module further includes the first lens 4 for converging the plurality of laser beams emitted from the semiconductor laser device each on a different focal point, the prism 97 for synthesizing the plurality of laser beams traveling through the first lens 4, and the optical fiber 8 for receiving the laser beams emerging from the prism 97 and letting the beams travel outside.

The stripes 9a, 9b, 9c of the semiconductor laser device 2 include the diffraction gratings 75 described above, each stripe emitting laser beam of different wavelength from the others.

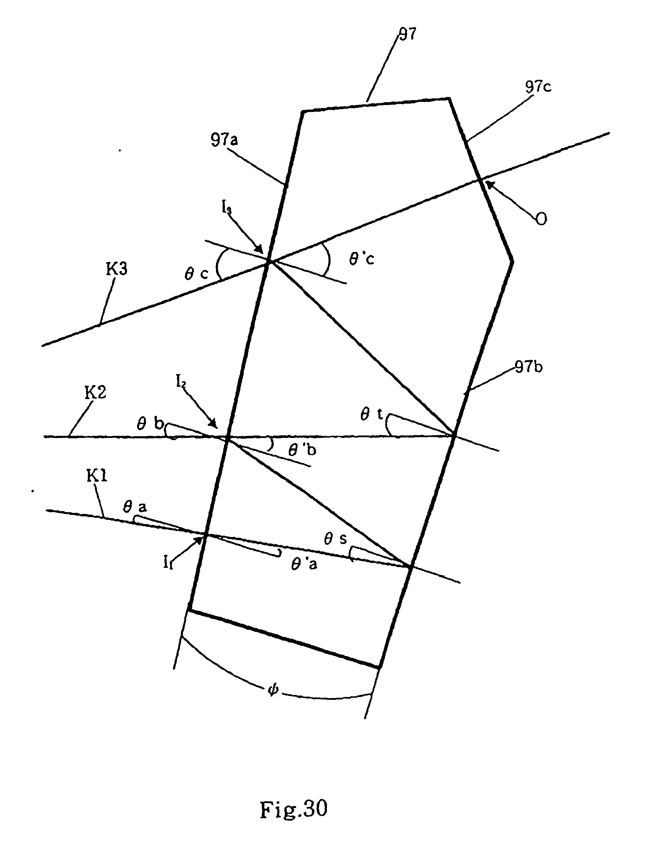

The seventeenth embodiment uses, as shown in FIG 30, a wedge-shaped prism 97. The incident surface of this wedge-shaped prism is formed with a wavelength selection filter 97a composed of, e.g., dielectric multi-layer film that reflects or transmits the incident laser beam depending on the wavelength and the incident angle thereof.

Further, the exit surface of the wedge-shaped prism is formed with a total reflection layer (reflection part) 97b for reflecting the beams irrespective of the wavelengths, and an antireflection layer (output part) 97'c for preventing the

reflection.

In the seventeenth embodiment, the prism 97 is inclined so that the laser beams K1, K2, K3 are incident upon the wavelength selection filter 97a at an angle θa, θb, θc respectively, with the wavelengths of the laser beams K1, K2, K3 being set to λa□λb □λc, respectively.

In this case, the first laser beam K1, incident on the first input part I$_l$ of the wavelength selection filter 97a at the angle θa, propagates at the angle θ'a through the prism 97 with the refractive index Np. Then, the first laser beam K1 is reflected at an angle θs (θa + wedge angleΨ) from the total reflection layer 97b (the reflection part) and reaches the second input part I$_2$ for the second laser beam K2.

The second laser beam K2, incident on the second input part I$_2$ of the wavelength selection filter 97a at the angle θb, propagates at the angle θ'b through the prism 97 with the refractive index Np. Since the first laser beam K1 is reflected at the angle θ'b (θs + wedge angleΨ) from the second input part I$_2$ of the wavelength selection filter 97a, the first and second laser beams K1, K2 are synthesized. The synthesized laser beam (K1 + K2) is reflected at an angle θt (θ'b + wedge angleΨ) from the total reflection layer 97b and reaches a third input part I$_3$ for the third laser beam K3.

The third laser beam K3, incident on the third input part I$_3$ of the wavelength selection filter 97a at the angle θc, propagates at the angle θ'c through the prism with the refractive index Np. Since the synthesized laser beam (K1 + K2) is reflected at an angle θ'c (θt + wedge angleΨ) from the third input part I$_3$ of the wavelength selection filter 97a, the third laser beam K3 and the synthesized laser beam (K1 + K2) are synthesized. The synthesized laser beam (K1 + K2 + K3) travels through the output part O formed with the antireflection layer 97c.

Note here in this embodiment that the each beam experiences different times of reflections inside the prism 97, which result in the difference in optical path lengths propagated by each beam. When coupling these beams to a single thread of optical fiber 8, since they have beam waists at different positions with each other, it is difficult to obtain high coupling efficiencies for all of these beams. Therefore, it is required that the optical path length be corrected to be substantially the same.

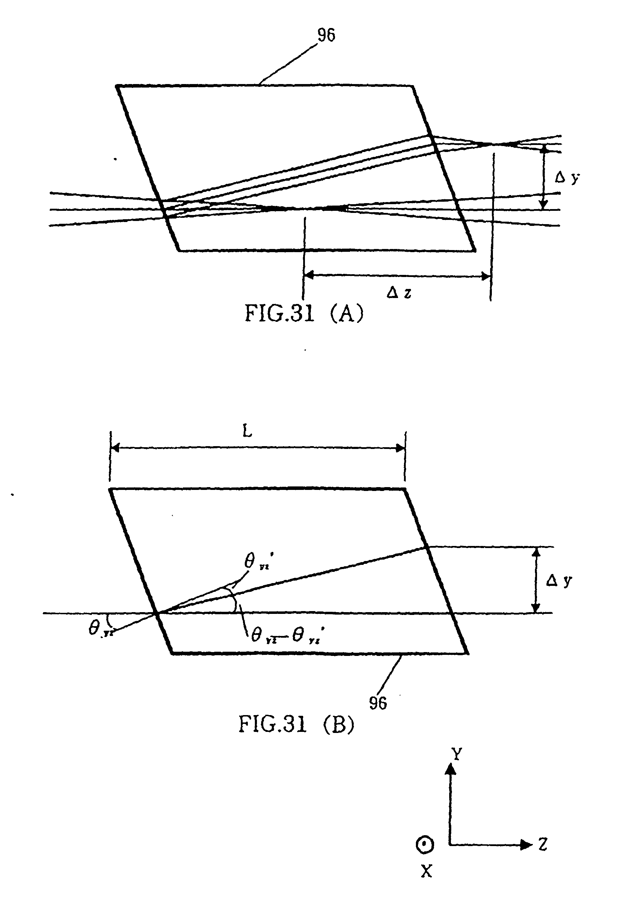

For_that purpose, an optical path correction prism 96 for correcting the optical path of the first laser beam K1 is disposed in front of the prism 97 (see FIG.29(A) and FIG. 31).

The optical path correction prism 96 is capable of correcting not only a deviation Δz of the beam waist in the direction of propagation (z-direction) of the Gaussian laser beam emitted from each stripe, but also the deviations Δx, Δy, in the plane perpendicular to the direction of propagation (in the direction of x or y). (Note here that in FIG.31, x-axis orients from face to back of the sheet, y-axis from bottom to top, z-axis from left to right.)

Herein, the following relationships are established for the correction Δy:

$$Sin\theta yz = Nc\sin\theta yz'$$

$$\Delta y = L \cdot \tan(\theta yz - \theta yz') / (1 - \tan(\theta yz - \theta yz') \tan\theta yz) \doteq L\theta yz \, (rad) \cdot (1 - 1/Nc),$$

where L is the length of the optical path correction prism 96 along the optical axis, θyz is the angle of incidence in the yz-plane, θyz' is the angle of refraction in the same plane, and Nc is the refractive index of the optical path correction prism. Note that the correction Δx can be expressed similarly using angles of incidence and refraction θzx and θzx' which are defined in zx-plane.

Further, the correction Δz can be expressed as :

$$\Delta z \doteq (1 - 1/Nc)L$$

The above expressions teaches that the optical path correction prism 96 is capable of correcting not only the optical path length along z-direction (Δz) but also the deviation of the beam which will occur in xy-plane ( i.e. of the beam waist; Δx and Δy), the latter being attained by adjustingly rotating the optical path correction prism 96 around y and x axis.

Thus, according to the seventeenth embodiment, since the optical path correction prism 96 is inserted, the difference in the optical path length can be substantially completely corrected. Similarly, the optical path correction prism 96 may be inserted on the optical path of the second laser beam K2 in order to correct the difference in the optical path length.

Further, according to the seventeenth embodiment, since the optical path correction prism 96 is disposed on the optical path of the laser beam, an optical coupling efficiency to the optical fiber 8 of approximately 80% or more can be obtained for each laser beam even if the maximum allowable manufacturing tolerance of each component is comparatively slackened.

Note that in the seventeenth embodiment, since the first lens 4 functions to widen the divergence between a plurality of laser beams so that they are independent and not overlapping with each other, it is possible to insert an optical path correction prism 96 on the optical path of each laser beam.

The optical module in the seventeenth embodiment is designed based on, e.g., the following numerical values and can be thereby embodied.

(1) The oscillation wavelength of each of the stripes of the semiconductor laser device : λa = 1490 nm, λb = 1470 nm, λc = 1450 nm;

(2) The beam spot size (radius) at the light-exit surface (front edge surface) of the semiconductor laser device : wLD = 1.7 μm;

(3) The distance between the first stripe 9a and the optical axis C of the first lens 4 : da = - tanαa · f2 = -38.4μm;

(4) The optical path for the second laser beam K2 is aligned to be coincident with the central axis C of the first lens 4;

(5) The distance between the third stripe 9c and the optical axis C of the first lens 4 : dc = - tanαc · f2 = 38.6μm;

(6) The focal length of the first lens 4 : f2 = 720 μm;

(7) The angle made between the optical axis C of the first lens 4 and the first laser beam K1 : αa = θa -θb = -3.05°;

(8) The angle made between the optical axis C of the first lens 4 and the third laser beam K3 : αc = θc - θa = 3.07°;

(9) The parameter of prism 97 : Ψ(wedge angle) = 1°, Np = 1.5;

(10) The thickness of the prism 97 in the incident position of the first laser beam K1 : t = 1mm;

(11) The angle of incidence and refraction of the laser beams by the prism 97 : θa = 12.050°, θ'a= 8°, θb = 15.10°, θ'b = 10°, θc = 18.17°, θ'c = 12°;

(12) The interval between the incident positions of the first and second laser beams K1, K2 : $\Delta y1 \doteqdot 2(\tan\theta a +\Psi)t \doteqdot$ 0.462 mm;

(13) The interval between the incident positions of the second and third laser beams K2, K3 : $\Delta y2 \doteqdot 2(\tan\theta a + 2\Psi/\cos^2\theta a +\Psi) t \doteqdot 0.535$ mm;

(14) The distance along the optical axis from the intersecting position of the three beams_to the edge surface of the prism 97 : $D = \Delta y2/ (\theta c - \theta b) (rad) = 10.0$ mm;

(15) The cut-off wavelengths of the wavelength selection filter 97a : λx(θa) = 1502,77 nm, λx(θb) = 1483.57 nm, λx (θc) = 1460 nm, λx (0) = 1536.62 nm;

With the above-mentioned parameters, the difference in the optical path lengths between the first laser beam K1 and the third laser beam K3 is about 2.5 mm. The optical path correction prism 96 to correct the difference may be, for example, composed of silicon (refractive index Nc =3.4) and 3.5 mm in length (L). Referring to FIG.31, the resulting amount of correction Δz is calculated as :

$$\Delta z \doteqdot (1 - 1/Nc)\, L \doteqdot 2.5 \text{ mm}$$

and the amount of correction Δy as :

$$\Delta y = D\, (\theta b - \theta a)\, (rad) - \Delta y1 = 0.070 \text{ mm}$$

with the angle of incidence in the yz-plane θyz □ 1.25°.

Note that if the first lens 4 and the second lens 16 are positioned such that the beam spot size therebetween is smaller than in the case of the beam being collimated therebetween, a larger deviation in the intersecting angle θ of the beams that have traveled through the first lens 4 can be tolerated, whereby a larger manufacturing tolerance in the wedge angle (Ψ) of the prism (of ± 0.05°), and in the spacings (da, dc) of the stripes (of ± 0.1 μm) are tolerated. Therefore, it becomes possible to position the prism 97 with no severe precision for low loss synthesization to be realized.

In generalizing the sixteenth and seventeenth embodiments, when the laser beams having first to n-th wavelengths are emitted from the first to n-th (n is an integer that is 2 or larger) stripes of the semiconductor laser device 2, the prism 97 includes first to n-th input parts upon which the laser beams of the first through n-th wavelengths are incident, a reflection part for totally reflecting the laser beams, and an output part. The i-th (i includes all the integers of 2 to n) input parts and the reflection part function such that the first to (i-1)th beam entering the light synthesizing element from the first to (i-1)th input part is reflected by the reflection part toward the i-th input part and further reflected by the i-th input part in the traveling direction of the beam of the i-th wavelength, and synthesized with the beam of the i-th wavelength. The thus synthesized beams having the first to n-th wavelengths are coupled to the optical fiber via the output part.

An example useful for the understanding is that of the semiconductor laser module exemplified in one of the first through seventeenth embodiments, as applied to a Raman amplifier.

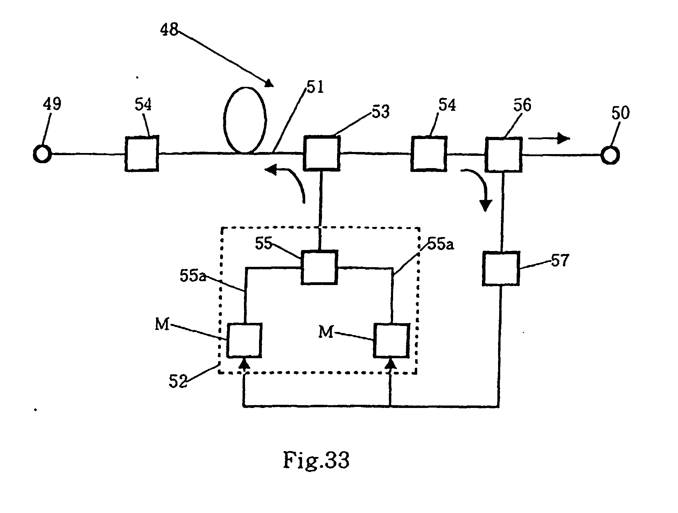

FIG 33 is a block diagram showing a configuration of the Raman amplifier shown in the example useful for the understanding of the present invention. This Raman amplifier is used in, e.g., a WDM communication system. As shown in FIG 33, a Raman amplifier 48 includes an input unit 49 for inputting the signal beam, an output unit 50 for outputting the signal beam, an optical fiber (amplification fiber) 51 through which the signal light is transmitted between the input unit 49 and the output unit 50, a pumping beam generating unit 52 for generating the pumping beam, and a WDM coupler 53 for multiplexing the pumping beam generated by the pumping beam generating unit 52 with the signal beam transmitted through the optical fiber (amplification fiber) 51, and optical isolators 54 that transmit only the signal beam traveling from the input unit 49 toward the output unit 50, are provided between the input unit 49 and the WDM coupler 53 and between the output unit 50 and the WDM coupler 53.

The pumping beam generating unit 52 includes a plurality semiconductor laser modules for emitting the laser beams having wavelength ranges different from each other in the first through seventeenth embodiment, and a WDM coupler 55 for synthesizing the laser beams emitted from the semiconductor laser modules M.

The pumping beams emitted from the semiconductor laser modules M are synthesized by the WDM coupler 55 through a polarization maintaining fiber 55a, and exit the pumping beam generating unit 52.

The pumping beams generated by the pumping beam generating unit 52 are coupled to the optical fiber 51 by the WDM coupler 53. The signal beams inputted from the input unit 49 are multiplexed with the pumping beams and amplified in the optical fiber 51, then travel through the WDM coupler 53 and are outputted from the output unit 50.

The signal beams (amplified signal beams) amplified within the optical fiber 51 are inputted to a monitor beam distribution coupler 56 via the WDM coupler 53 and the optical isolators 54. The monitor beam distribution coupler 56 distributes some portion of the amplified signal beams to a control circuit 57, and the remaining portion of the amplified signal beams are outputted from the output unit 50.

The control circuit 57 controls a laser emission state, e.g., a light intensity of each semiconductor laser module M on the basis of the portion of the amplified signal beams inputted thereto, and performs feedback control so that a gain of the optical amplification becomes flat over wavelength.

In this Raman amplifier 48, if are used the semiconductor laser modules in which laser beams emitted from the two stripes are polarization-synthesized to have a decreased DOP, it is possible to obtain a high and stable gain with decreased dependency on the polarization of the signal light.

Moreover, if are used the semiconductor laser modules incorporating semiconductor laser devices with diffraction gratings in their stripes, it is possible to reduce the level of noise added to the amplified signal light, due to the decreased relative intensity noise (RIN) compared with the semiconductor laser modules with FBG

Furthermore, since the semiconductor laser device with the diffraction gratings 75 formed in the stripes has a plurality of longitudinal modes oscillating within the FWHM of the oscillation spectrum, it is possible to obtain stable, low-noise, and high Raman gain without causing stimulated Brillouin scattering.

Further, since the semiconductor laser modules emits laser beams of significantly decreased_DOP and noise, it is possible to obtain a stable gain with decreased dependency on the polarization of the signal light_not only in the backward-pumped Raman amplifier as shown in FIG.33 but also in the forward or bidirectionally pumped Raman amplifier.

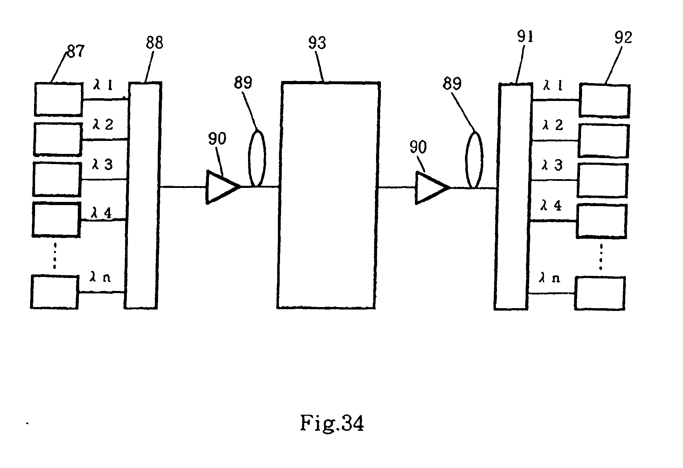

The Raman amplifier shown in FIG 33 can be, as explained above, applied to the WDM communication system. FIG 34 is a block diagram showing architecture of the WDM communication system to which the Raman amplifier shown in FIG 33 is applied.

Referring to FIG 34, the optical signals having wavelengths λ1 to λn that are transmitted from a plurality of transmitters 87, are multiplexed by an optical multiplexer 88 and converged at one length of optical fiber 89. A plurality of Raman amplifiers 90 each corresponding to the Raman amplifier shown in FIG 33 are disposed depending on the distance on the transmission path of the optical fiber 89, and amplify attenuated optical signals. The signals transmitted on the optical fiber 89 are demultiplexed by an optical demultiplexer 91 into optical signals having the plurality of wavelength λ1 to λn, and received by a plurality of receivers 92. Note that an ADM (Add/Drop Multiplexer) 93 for adding and dropping the optical signal having an arbitrary wavelength might be provided on the transmission path.

The present invention can be modified in many forms within the range of the technical items set forth in the following claims without being limited to the embodiments discussed above.

In the semiconductor laser modules M in the embodiments discussed above, the semiconductor laser device 2 and the holder member 14 are cooled by the same cooling device 20, however, the temperatures of the semiconductor laser device 2 and the holder member 14 may be controlled independently by use of separate cooling devices.

Further, the polarization rotating element involves the use of the half-wave plate 6, however, the polarizing plane may be rotated by use of, for instance, the Faraday element. In this case, the Faraday element is disposed inwardly of the coil, and an intensity of a magnetic field applied to the Faraday element can be varied by changing the electric current flowing through the coil. With this arrangement, a fluctuation in the wavelength of the laser beam and a fluctuation in the rotational angle of the polarizing direction due to a fluctuation in the temperature, can be individually compensated by adjusting the magnitude of the electric current flowing through the coil.

Moreover, it is obvious that the semiconductor laser module in each of the embodiments discussed above can be used as not only the pumping light source for the Raman amplification but also, for example, as the pumping light source for EDFA in 980nm or 1480nm band. Moreover, the semiconductor laser module in each of the embodiments of the present invention can be used as a signal light source.

Further, the number of the stripes formed in the present semiconductor laser device 2 is not limited to 2 or 3 but may be 4 or more.

Obviously, additional numerous modifications and variations of the present invention are possible in light of the above teachings. It is therefore to be understood that within the scope of the appended claims, the present invention may be practiced otherwise than as specifically described herein.

**Claims**

1. A semiconductor laser module (M1) comprising:

   a single semiconductor laser device having a first light emitting stripe (9) and at least one other light emitting stripe (10) which are aligned to respectively emit a first laser beam (K1) and at least one other laser beam (K2) through one edge surface, said first laser beam and said at least one other laser beam being separated by a first predetermined distance when emitted through said one edge surface:
   a single first lens (4) positioned so that the first laser beam and the at least one other laser beam emitted from the semiconductor laser device are incident thereon, the first lens configured to deflect at least one of the first laser beam and the at least one other laser beam;
   a beam synthesizing member (7;59;60) positioned downstream, in a beam propagating direction, of said first lens, said beam synthesizing member including

   a first input part (7a) on which the first laser beam is incident,
   at least one other input part (7b) on which the at least one other laser beam is incident, said first laser beam and said at least one other laser beam being separated by a second predetermined distance when incident on said beam synthesizing member, and
   an output part (7c) from which the first laser beam emerging from the first input part and the at least one other laser beam emerging from the at least one other input part are combined and emitted as a combined laser beam: and

   an optical fiber (8) positioned to receive the combined laser beam therein,
   wherein said second predetermined distance is larger than said first predetermined distance; and
   wherein the first light emitting stripe and at least one other light emitting stripe in the semiconductor laser device (2) are separated by not more than 100 μm.

2. The semiconductor laser module according to claim 1, wherein the polarization plane of the first laser beam and the at least one other laser beam are coincident with each other.

3. The semiconductor laser module according to claim 1, further comprising: a second lens (16) configured to couple the combined laser beam to the optical fiber.

4. The semiconductor laser module (M1) according to claim 3, wherein:

   the first lens (4) and the second lens (16) are positioned so that the first laser beam (K1) and the at least one other laser beam (K2) are focused to a point between the first lens and the second lens.

5. The semiconductor laser module according to any one of the preceding claims, wherein: the first lens (4) is positioned so that an optical axis of the first laser beam emitted from the first light emitting stripe (9) and an optical axis of the at least one other laser beam emitted from the at least one other light emitting stripe (10) are substantially symmetric about a center axis of the first lens.

6. The semiconductor laser module (M1) according to any one of the preceding claims, further comprising: a light receiving element (3) positioned to receive light emitted from the first laser emitting stripe (9) and the at least one other laser emitting stripe (10).

7. The semiconductor laser module according to claim 6, wherein: the light receiving element (3) is positioned to receive and monitor the first laser beam (K1) and the at least one other laser beam (K2) emitted from an other edge surface (2b) of the semiconductor laser device.

8. The semiconductor laser module (M1) according to any one of claims 6 to 7, wherein: the light receiving element (3) is a waveguide light receiving element.

9. The semiconductor laser module according to any one of claims 6 to 8, further comprising: a lens (95) disposed between the semiconductor laser device (2; 68; 84; 85) and the light receiving element (3) to split the first laser beam and the at least one other laser beam so as to expand a separation between the first laser beam and the at least one other laser beam.

10. The semiconductor laser module according to any one of claims 6 to 9, wherein: the light receiving element (3) is configured to receive and monitor respective portions of the first laser beam (K1) and the at least one other laser beam (K2) reflected by an arbitrary optical component arranged between the semiconductor laser device and optical fiber (8).

11. The semiconductor laser module (M1) according to any one of the preceding claims, wherein: the first light emitting stripe (9) and the at least one other light emitting stripe (10) in the semiconductor laser device (2) extend parallel to each other.

12. The semiconductor laser module according to any one of the preceding claims, wherein: the first light emitting stripe (9) and the at least one other light emitting stripe (10) are the only light emitting stripes in the semiconductor laser device.

13. The semiconductor laser module according to any one of the preceding claims, wherein: the first light emitting stripe (9) and the at least one other light emitting stripe (10) in the semiconductor laser device are inclined relative to each other.

14. The semiconductor laser module (M1) according to any one of the preceding claims, wherein: the first light emitting stripe (9) and the at least one other light emitting stripe (10) in the semiconductor laser device are configured to be simultaneously driven.

15. The semiconductor laser module according to any of the preceding claims, wherein: the first light emitting stripe (9) and the at least one other light emitting stripe (10) in the semiconductor laser device (2) are configured to be independently driven in a way that electrically insulates at least one side of a positive electrode and a negative electrode of the first light emitting stripe and the at least one other light emitting stripe.

16. The semiconductor laser module (M1) according any one of the preceding claims, wherein: the semiconductor laser device (2) is an InP-series BH buried heterostructure laser.

17. The semiconductor laser module according to any one of claims 1 to 15, wherein: the semiconductor laser device (2) is a GaAs-series ridge waveguide laser.

18. The semiconductor laser module (M1) according to any one of the preceding claims, wherein: the semiconductor laser device (2) is configured to operate as a pumping light source in an inclusive range of 1300 nm through 1550 nm for a Raman amplifier.

19. The semiconductor laser module according to any one of the preceding claims, wherein: the semiconductor laser device (2) is configured to operate as a pumping light source in at least one of a 980 nm band and 1480 nm band for EDFA.

20. The semiconductor laser module (M1) according any one of the preceding claims, wherein: the beam synthesizing member (59; 60) comprises at least one of a polarization beam combiner (7) and a prism (5).

21. The semiconductor laser module according to claim 20, wherein: the polarization beam combiner (7) is a birefringence element configured to propagate any one of the first laser beam (K1) and the at least one other laser beam (K2) as a normal ray and to propagate another of the at least one of the first laser beam and the at least one other laser beam as an extraordinary ray.

22. The semiconductor laser module (M1) according to any one of the preceding claims, wherein: the first input part (7a) and the at least one other input part (7b) of the beam synthesizing member (7; 59; 60) are inclined relative to each other.

23. The semiconductor laser module (M1) according to any one of the preceding claims, wherein: the first input part (7a) and the at least one other input part (7b) of the beam synthesizing member are a common part that is perpendicular to an optical axial direction of the semiconductor laser module.

24. The semiconductor laser module (M2;M3) according to any one of claims 1 to 22, wherein: the first input part (7a) and the at least one other input part (7b) of the beam synthesizing member are a common part that is not perpendicular to an optical axial direction of the semiconductor laser module.

25. The semiconductor laser module according to any one of the preceding claims, wherein: the beam synthesizing member is further configured to multiplex at least three laser beams.

26. The semiconductor laser module according to any one of the preceding claims, further comprising: a optical path correction prism (96) positioned between the first lens (4) and the beam synthesizing member.

27. The semiconductor laser module according to any one of the preceding claims, wherein: the semiconductor laser device (2) and the first lens (4) are disposed with inclinations at predetermined angles to an optical axial direction of the semiconductor laser module (M3) so that the first laser beam (K1) is directed to propagate in an axial direction of the optical fiber (8).

28. The semiconductor laser module(M1; M2; M3) according to any one of the preceding claims, further comprising: a prism disposed between the first lens and the beam synthesizing member positioned to receive and collimate the first laser beam and the at least one other laser beam.

29. The semiconductor laser module according to any one of the preceding claims, further comprising: a polarization rotating element positioned between the first lens and the beam synthesizing member, wherein the polarization rotating element is configured to rotate a polarizing plane of at least one of the first laser beam and the at least one other laser beam.

30. The semiconductor laser module according to claim 29, wherein: the polarization rotating element is a half wave plate.

31. The semiconductor laser module (M1; M2: M3) according to anyone of the preceding claims, further comprising: a beam reflection part (15) configured to reflect a predetermined wavelength of the combined laser beam back to the semiconductor laser device (2; 68; 84; 85).

32. The semiconductor laser module according to claim 31, wherein: the beam reflection part (15) includes a fiber Bragg grating.

33. The semiconductor laser module according to any one of the preceding claims, wherein: the optical fiber (8) is a polarization maintaining fiber.

34. The semiconductor laser module according to any one of the preceding claims, wherein: at least one of the first light emitting stripe (9) and the at least one other light emitting stripe (9) of the semiconductor laser device include a diffraction grating (75).

35. The semiconductor laser module according to claim 34, wherein: the diffraction grating (75) of at least one of the first light emitting stripe (9) and the at least one other light emitting stripe (10) of the semiconductor laser device (68) are disposed uniformly across an entire cavity length (LR) of the semiconductor laser device.

36. The semiconductor laser module according to any one of claims 34 to 35, wherein: the diffraction grating (75) of at least one of the first light emitting stripe (9) and the at least one other light emitting stripe (10) of the semiconductor laser device extend along a cavity length of the semiconductor laser device of at least 800 μm and are configured to produce a plurality of longitudinal oscillation modes (83) within a predetermined wavelength band (82).

37. The semiconductor laser module according to claim 34, wherein: the diffraction grating (75) of at least one of the first light emitting stripe and the at least one other light emitting stripe of the semiconductor laser device (84) are disposed uniformly across at least one portions, but not an entire length, of a cavity length of the semiconductor laser device (2).

38. The semiconductor laser module according to claim 34, wherein: the diffraction grating (75) of at least one of the first light emitting stripe and the at least one other light emitting stripe of the semiconductor laser device (85) comprises a periodically changed grating period.

39. The semiconductor laser module according to any one of claims 34 to 38, wherein: the diffraction gratings (75) of the first light emitting stripe (9) and the at least one other light emitting stripe (10) of the semiconductor laser device (68; 84;85) are configured so that wavelengths emitted by the first light emitting stripe and the at least one other light emitting stripe are selectively set to be a same wavelength.

40. The semiconductor laser module (M1; M2; M3) according to any one of claims 34 to 38, wherein: the diffraction gratings (75) of the first light emitting stripe and the at least one other light emitting stripe of the semiconductor laser device (68; 84; 85) are configured so that wavelengths emitted by the first light emitting stripe and the at least one other light emitting stripe are selectively set to be different.

41. The semiconductor laser module according to any one of the preceding claims, wherein: the first light emitting stripe and the at least one other light emitting stripe in the semiconductor laser device (2) are configured to be independently driven in a way that electrically insulates at least one side of a positive electrode and a negative electrode of the first light emitting stripe (9) and the at least one other light emitting stripe (10).

42. The semiconductor laser module according to any one of claims 1 to 30 or 33 to 41, further comprising: an optical isolator (94) positioned between the first lens (4) and the beam synthesizing member where the first laser beam (K1) and the at least one other laser beam (K2) are parallel relative to each other, wherein the optical isolator is configured to stabilize the semiconductor laser module by preventing a laser beam reflection.

43. The semiconductor laser module according to any one of the preceding claims, further comprising: a cooling device (20) configured to cool the semiconductor laser device, and a base plate module having a first base plate (17) on which the semiconductor laser device is fixed and a second base plate (18) disposed onto the first base plate and on which the beam synthesizing member (59;60) is fixed.

44. The semiconductor laser module according to claim 43, wherein: the cooling device is a heat sink comprising a plurarity of Peltier elements disposed under the base plate module and
the cooling device (20) is configured to keep a constant temperature and to increase and stabilize the first laser beam (K1) and the at least one other laser beam (K2) emitted from the semiconductor laser device.

45. The semiconductor laser module according to any one of claims 43 to 44, further comprising: a thermistor (20a) configured to detect a change in temperature due to heat transferred from the semiconductor laser device and to input a signal into the cooling device.

**Patentansprüche**

1. Ein Halbleiter-Laser-Modul (M1), umfassend:

ein einzelnes Halbleiter-Laser-Gerät mit einem ersten lichtemittierenden Streifen (9) und mindestens einem weiteren lichtemittierenden Streifen (10), die jeweils ausgerichtet sind, um ein ersten Laserstrahl (K1) bzw. mindestens einen weiteren Laserstrahl (K2) durch eine Randfläche zu emittieren, wobei der erste Laserstrahl und der mindestens eine weitere Laserstrahl durch einen ersten vorbestimmten Abstand separiert sind, wenn sie durch die eine Randfläche emittiert werden;
eine einzelne erste Linse (4), so angeordnet, dass der erste Laserstrahl und der mindestens eine weitere Laserstrahl, die aus dem Halbleiter-Laser-Gerät emittiert werden, darauf einstrahlen, wobei die erste Linse konfiguriert ist, mindestens einen von dem ersten Laserstrahl und dem mindestens einen weiteren Laserstrahl abzulenken;

ein Strahl-Synthetisierungs-Element (7; 59; 60), in einer Strahl-Ausbreitungs-Richtung strahlabwärts der ersten Linse angeordnet, wobei das Strahl-Synthetisierungs-Element enthält:

ein erstes Eingangs-Teil (7a), auf welches der erste Laserstrahl einstrahlt,

mindestens ein weiteres Eingangs-Teil (7b), auf welches der mindestens eine weitere Laserstrahl einstrahlt, wobei der erste Laserstrahl und der mindestens eine weitere Laserstrahl durch einen zweiten vorbestimmten Abstand separiert sind, wenn sie auf das Strahl-Synthetisierungs-Element einstrahlen, und

ein Ausgangs-Teil (7c), aus dem der aus dem ersten Eingangs-Teil hervorgehende erste Laserstrahl und der aus dem mindestens einen weiteren Eingangs-Teil hervorgehende mindestens eine weitere Laserstrahl kombiniert und als ein kombinierter Laserstrahl emittiert werden; und

eine optische Faser (8), angeordnet, um den kombinierten Laserstrahl darin zu empfangen,

wobei der zweite vorbestimmte Abstand größer als der erste vorbestimmte Abstand ist; und

wobei der erste lichtemittierende Streifen und der mindestens eine weitere lichtemittierende Streifen in dem Halbleiter-Laser-Gerät (2) durch nicht mehr als 100 $\mu$m separiert sind.

2. Das Halbleiter-Laser-Modul nach Anspruch 1, wobei die Polarisationsebene des ersten Laserstrahls und des mindestens einen weiteren Laserstrahls miteinander übereinstimmen.

3. Das Halbleiter-Laser-Modul nach Anspruch 1, weiter umfassend: eine zweite Linse (16), konfiguriert, um den kombinierten Laserstrahl an die optische Faser zu koppeln.

4. Das Halbleiter-Laser-Modul (M1) nach Anspruch 3, wobei die erste Linse (4) und die zweite Linse (16) so angeordnet sind, dass der erste Laserstrahl (K1) und der mindestens eine weitere Laserstrahl (K2) auf einen Punkt zwischen der ersten Linse und der zweiten Linse fokussiert werden.

5. Das Halbleiter-Laser-Modul nach einem der vorhergehenden Ansprüche, wobei die erste Linse (4) so angeordnet ist, dass eine optische Achse des aus dem ersten lichtemittierenden Streifen (9) emittierten ersten Laserstrahls und eine optische Achse des aus dem mindestens einen weiteren lichtemittierenden Streifen (9) emittierten mindestens einen weiteren Laserstrahls im Wesentlichen symmetrisch bezüglich einer Mittelachse der ersten Linse sind.

6. Das Halbleiter-Laser-Modul (M) nach einem der vorhergehenden Ansprüche, weiter umfassend: ein lichtempfangendes Element (3), angeordnet, um von dem ersten laseremittierenden Streifen (9) bzw. dem mindestens einen weiteren laseremittierenden Streifen (10) emittiertes Licht zu empfangen.

7. Das Halbleiter-Laser-Modul nach Anspruch 6, wobei das lichtempfangende Element (3) angeordnet ist, um den ersten Laserstrahl (K1) und den mindestens einen weiteren Laserstrahl (K2), emittiert von einer weiteren Randfläche (2b) des Halbleiter-Laser-Geräts, zu erhalten und zu überwachen.

8. Das Halbleiter-Laser-Modul (M1) nach einem der Ansprüche 6 bis 7, wobei das lichtempfangende Element (3) ein Wellenleiter-Licht-empfangendes Element ist.

9. Das Halbleiter-Laser-Modul nach einem der Ansprüche 6 bis 8, weiter umfassend: eine Linse (95), die zwischen dem Halbleiter-Laser-Gerät (2; 68; 84; 85) und dem lichtempfangenden Element (3) angeordnet ist, um den ersten Laserstrahl und den mindestens einen weiteren Laserstrahl aufzuspalten, um eine Separation zwischen dem ersten Laserstrahl und dem mindestens einen weiteren Laserstrahl zu erweitern.

10. Das Halbleiter-Laser-Modul nach einem der Ansprüche 6 bis 9, wobei das lichtempfangende Element (3) konfiguriert ist, um jeweilige Teile des ersten Laserstrahls (K1) und des mindestens einen weiteren Laserstrahls (K2), die durch eine beliebige zwischen dem Halbleiter-Laser-Gerät und dem Glasfaserkabel (8) angeordnete optische Komponente reflektiert sind, zu empfangen und zu überwachen.

11. Das Halbleiter-Laser-Modul (M1) nach einem der vorhergehenden Ansprüche, wobei: der erste lichtemittierende Streifen (9) und der mindestens eine weitere lichtemittierende Streifen (10) sich in dem Halbleiter-Laser-Gerät (2) parallel zueinander erstrecken.

12. Das Halbleiter-Laser-Modul nach einem der vorhergehenden Ansprüche, wobei: der erste lichtemittierende Streifen (9) und der mindestens eine weitere lichtemittierende Streifen (10) die einzigen lichtemittierenden Streifen in den Halbleiter-Laser-Gerät sind.

13. Das Halbleiter-Laser-Modul nach einem der vorhergehenden Ansprüche, wobei: der erste lichtemittierende Streifen (9) und der mindestens eine weitere lichtemittierende Streifen (10) in dem Halbleiter-Laser-Gerät zueinander geneigt sind.

14. Das Halbleiter-Laser-Modul (M1) nach einem der vorhergehenden Ansprüche, wobei: der erste lichtemittierende Streifen (9) und der mindestens eine weitere lichtemittierende Streifen (10) in dem Halbleiter-Laser-Gerät konfiguriert sind, um gleichzeitig betrieben zu werden.

15. Das Halbleiter-Laser-Modul nach einem der vorhergehenden Ansprüche, wobei: der erste lichtemittierende Streifen (9) und der mindestens eine weitere lichtemittierende Streifen (10) in dem Halbleiter-Laser-Gerät (2) konfiguriert sind, um unabhängig voneinander betrieben zu werden, in einer Weise, die mindestens eine Seite einer positiven Elektrode und einer negativen Elektrode des ersten lichtemittierenden Streifens und des mindestens einen weiteren lichtemittierenden Streifen elektrisch isoliert.

16. Das Halbleiter-Laser-Modul (M1) nach einem der vorhergehenden Ansprüche, wobei: das Halbleiter-Laser-Gerät (2) ein Laser mit einer InP-Serien-BH-begrabenen Heterostruktur ist.

17. Das Halbleiter-Laser-Modul nach einem der Ansprüche 1 bis 15, wobei: das Halbleiter-Laser-Gerät (2) ein GaAs-Serien-Steg-Wellenleiter-Laser ist.

18. Das Halbleiter-Laser-Modul (M1) nach einem der vorhergehenden Ansprüche, wobei: der Halbleiter-Laser-Gerät (2) konfiguriert ist, um als eine Pumplichtquelle in einem Bereich von 1300 nm bis einschließlich 1550 nm für einen Raman-Verstärker zu operieren.

19. Das Halbleiter-Laser-Modul nach einem der vorhergehenden Ansprüche, wobei: das Halbleiter-Laser-Gerät (2) konfiguriert ist, um als Pumplichtquelle in mindestens einem eines 980 nm- und eines 1480 nm-Bands für EDFA zu operieren.

20. Das Halbleiter-Laser-Modul (M1) nach einem der vorhergehenden Ansprüche, wobei: das Strahl-Synthetisierungs-Element (59, 60) mindestens eines von einem Polarisations-Strahl-Kombinierer (7) und einem Prisma (5) umfasst.

21. Das Halbleiter-Laser-Modul nach Anspruch 20, wobei: der Polarisations-Strahl-Kombinierer (7) ein doppelbrechendes Element ist, konfiguriert, um irgendeinen von dem ersten Laserstrahl (K1) und dem mindestens einen weiteren Laserstrahl (K2) als einen normalen Strahl zu propagieren, und um einen anderen von zumindest einem des ersten Laserstrahls und des mindestens einen weiteren Laserstrahls als einen außerordentlichen Strahl zu propagieren.

22. Das Halbleiter-Laser-Modul (M1) nach einem der vorhergehenden Ansprüche, wobei: das erste Eingangs-Teil (7a) und das mindestens eine weitere Eingangs-Teil (7b) des Strahl-Synthese-Elements (7; 59; 60) relativ zueinander geneigt sind.

23. Das Halbleiter-Laser-Modul (M1) nach einem der vorhergehenden Ansprüche, wobei: das erste Eingangs-Teil (7a) und das mindestens eine weitere Eingangs-Teil (7b) des Strahl-Synthese-Elements (7; 59; 60) ein gemeinsames Teil sind, das senkrecht zu einer optischen axialen Richtung des Halbleiter-Laser-Moduls ist.

24. Das Halbleiter-Laser-Modul (M2, M3) nach einem der Ansprüche 1 bis 22, wobei: das erste Eingangs-Teil (7a) und das mindestens eine weitere Eingangs-Teil (7b) des Strahl-Synthese-Elements (7; 59; 60) ein gemeinsames Teil sind, das nicht senkrecht zu einer optischen axialer Richtung des Halbleiter-Laser-Moduls ist.

25. Das Halbleiter-Laser-Modul nach einem der vorhergehenden Ansprüche, wobei: das Strahl-Synthese-Element weiter konfigriert ist, um mindestens drei Laserstrahlen zu multiplexen.

26. Das Halbleiter-Laser-Modul nach einem der vorhergehenden Ansprüche, weiter umfassend: ein optisches Pfad-Korrektur-Prisma (96), angeordnet zwischen der ersten Linse (4) und dem Strahl- Synthese-Element.

**27.** Das Halbleiter-Laser-Modul nach einem der vorhergehenden Ansprüche, wobei: das Halbleiter-Laser-Gerät (2) und die erste Linse (4) mit Neigungen mit vorbestimmten Winkeln zu einer optischen axialen Richtung des Halbleiter-Laser-Moduls (M3) aufgestellt sind, so dass der erste Laserstrahl (K1) gerichtet ist, um in einer axialen Richtung der optischen Faser (8) zu propagieren.

**28.** Das Halbleiter-Laser-Modul (M1, M2, M3) nach einem der vorhergehenden Ansprüche, weiter umfassend: ein Prisma, das aufgestellt ist zwischen der ersten Linse und dem Strahl-Synthese-Element, das angeordnet ist, um den ersten Laserstrahl und den mindestens einen weiteren Laserstrahl zu empfangen und zu kollimieren.

**29.** Das Halbleiter-Laser-Modul nach einem der vorhergehenden Ansprüche, weiter umfassend: ein polarisationsrotierendes Element, angeordnet zwischen der ersten Linse und dem Strahl-Synthese-Element, wobei das polarisationsrotierende Element konfiguriert ist, um eine Polarisationsebene mindestens eines von dem ersten Laserstrahl und dem mindestens einen weiteren Laserstrahl zu rotieren.

**30.** Das Halbleiter-Laser-Modul nach Anspruch 29, wobei: das polarisationsrotierende Element ist eine Halbwellen-Platte ist.

**31.** Das Halbleiter-Laser-Modul (M1, M2: M3) nach einem der vorhergehenden Ansprüche, weiter umfassend: ein Lichtstrahl-Reflexions-Teil (15), das konfiguriert ist, um eine vorgegebene Wellenlänge des kombinierten Laserstrahls zurück zu dem Halbleiter-Laser-Gerät (2; 68; 84; 85) zu reflektieren.

**32.** Das Halbleiter-Laser-Modul nach Anspruch 31, wobei: das Strahl-Reflexions-Teil (15) ein Faser-Bragg-Gitter umfasst.

**33.** Das Halbleiter-Laser-Modul nach einem der vorhergehenden Ansprüche, wobei: die optische Faser (8) eine polarisationserhaltende Faser ist.

**34.** Das Halbleiter-Laser-Modul nach einem der vorhergehenden Ansprüche, wobei: mindestens einer von dem ersten lichtemittierenden Streifen (9) und dem mindestens einen weiteren lichtemittierenden Streifen (9) des Halbleiter-Laser-Geräts ein Beugungsgitter (75) umfasst.

**35.** Das Halbleiter-Laser-Modul nach Anspruch 34, wobei: das Beugungsgitter (75) von mindestens einem des ersten lichtemittierenden Streifens (9) und des mindestens einen weiteren lichtemittierenden Streifens (10) des Halbleiter-Laser Gerät (68) gleichmäßig über eine ganzes Resonatorlänge (LR) des Halbleiter-Laser-Geräts angeordnet sind.

**36.** Das Halbleiter-Laser-Modul nach einem der Ansprüche 34 bis 35, wobei: das bzw. die Beugungsgitter (75) mindestens eines von dem ersten lichtemittierenden Streifen (9) und dem mindestens einen weiteren lichtemittierenden Streifen (10) des Halbleiter-Laser-Geräts sich entlang einer Kavitätslänge des Halbleiter- Laser-Geräts von mindestens 800 $\mu$m erstreckt bzw. erstrecken und konfiguriert ist bzw. sind, um eine Mehrzahl von longitudinalen Schwingungsmoden (83) innerhalb eines vorbestimmten Wellenlängenbands (82) zu produzieren.

**37.** Das Halbleiter-Laser-Modul nach Anspruch 34, wobei: der Beugungsgitter (75) mindestens eines von dem ersten lichtemittierenden Streifen und dem mindestens einen weiteren lichtemittierenden Streifen des Halbleiter-Laser-Geräts (84) gleichmäßig über wenigstens einen Teil, aber nicht eine ganze Länge einer Kavitäts-Länge des Halbleiter-Laser-Geräts (2) verteilt aufgestellt sind.

**38.** Das Halbleiter-Laser-Modul nach Anspruch 34, wobei: das Beugungsgitter (75) mindestens eines von dem ersten lichtemittierenden Streifen und dem mindestens einen weiteren lichtemittierenden Streifen des Halbleiter-Laser-Geräts (85) eine periodisch veränderliche Gitter-Periode umfasst.

**39.** Das Halbleiter-Laser-Modul nach einem der Ansprüche 34 bis 38, wobei: die Beugungsgitter (75) des ersten lichtemittierenden Streifens (9) und des mindestens einen weiteren lichtemittierenden Streifens (10) des Halbleiter-Laser Geräts (68, 84, 85) so konfiguriert sind, dass von dem ersten lichtemittierenden Streifen und dem mindestens einen weiteren lichtemittierenden Streifen emittierte Wellenlängen selektiv eingestellt sind, um eine gleiche Wellenlänge zu sein.

**40.** Das Halbleiter-Laser-Modul (M1, M2, M3) nach einem der Ansprüche 34 bis 38, wobei: die Beugungsgitter (75) des ersten lichtemittierenden Streifens (9) und des mindestens einen weiteren lichtemittierenden Streifens (10) des Halbleiter-Laser Gerät (68, 84, 85) so konfiguriert sind, dass von dem ersten lichtemittierenden Streifen und dem mindestens einen weiteren lichtemittierenden Streifen emittierte Wellenlängen selektiv eingestellt sind, um unterschiedlich zu sein.

41. Das Halbleiter-Laser-Modul nach einem der vorhergehenden Ansprüche, wobei: der erste lichtemittierende Streifen und der mindestens eine weitere lichtemittierende Streifen in dem Halbleiter-Laser-Gerät konfiguriert sind, um unabhängig voneinander in einer Weise betrieben zu werden, die mindestens eine Seite einer positiven Elektrode und einer negativen Elektrode des ersten lichtemittierenden Streifen (9) und des mindestens einen weiteren lichtemittierenden Streifens (10) elektrisch isoliert.

42. Das Halbleiter-Lasermodul nach einem der Ansprüche 1 bis 30 oder 33 bis 41, weiter umfassend: einen optischen Isolator (94), der zwischen der ersten Linse (4) und dem Strahl-Synthetisierungs-Element angeordnet ist, wo der erste Laserstrahl (K1) und der mindestens eine weitere Laserstrahl (K2) parallel zueinander sind, wobei der optische Isolator konfiguriert ist, um das Halbleiter-Laser-Modul durch die Verhinderung einer Laserstrahl-Reflexion zu stabilisieren.

43. Das Halbleiter-Laser-Modul nach einem der vorhergehenden Ansprüche, weiter umfassend: eine Kühleinrichtung (20), die konfiguriert ist, um das Halbleiter-Laser-Gerät zu kühlen; und ein Grundplatten-Modul mit einer ersten Grundplatte (17), auf der das Halbleiter-Laser-Gerät befestigt ist, und einer zweiten Grundplatte (18), die auf der ersten Grundplatte angeordnet ist und an welcher das Strahl-Synthetisierungs-Element (59, 60) befestigt ist.

44. Das Halbleiter-Laser-Modul nach Anspruch 43, wobei: die Kühleinrichtung ein Kühlkörper mit einer Mehrzahl von unter dem Bodenplatte-Modul angeordneten Peltier-Elementen ist; und
die Kühleinrichtung (20) konfiguriert ist, um eine konstante Temperatur zu halten und den ersten Laserstrahl (K1) und den mindestens einen weiteren Laserstrahl (K2), aus dem Halbleiter-Laser-Gerät emittiert, zu erhöhen und zu stabilisieren.

45. Das Halbleiter-Laser-Modul nach einem der Ansprüche 43 bis 44, weiter umfassend: einen Thermistor (20a), der konfiguriert ist, um eine Temperaturveränderung aufgrund von von dem Halbleiter-Laser-Gerät übertragener Wärme zu erkennen und um ein Signal in die Kühleinrichtung einzuspeisen.

**Revendications**

1. Module de laser à semi-conducteurs (M1) comprenant :

un dispositif laser à semi-conducteurs unique comportant une première bande d'émission de lumière (9) et au moins une autre bande d'émission de lumière (10) qui sont alignées pour émettre respectivement un premier faisceau laser (K1) et au moins un autre faisceau laser (K2) à travers une surface de bord, ledit premier faisceau laser et ledit au moins un autre faisceau laser étant séparés d'une première distance prédéterminée lorsqu'ils sont émis à travers ladite une surface de bord ;
une première lentille unique (4) positionnée de sorte que le premier faisceau laser et ledit au moins un autre faisceau laser émis par le dispositif laser à semi-conducteurs frappent celle-ci, la première lentille étant configurée pour défléchir au moins l'un du premier faisceau laser et dudit au moins un autre faisceau laser ;
un élément de synthèse de faisceaux (7 ; 59 ; 60) positionné en aval, dans une direction de propagation de faisceau, de ladite première lentille, ledit élément de synthèse de faisceaux comprenant :

une première partie d'entrée (7a) que le premier faisceau laser frappe,
au moins une autre partie d'entrée (7b) que ledit au moins un autre faisceau laser frappe, ledit premier faisceau laser et ledit au moins un autre faisceau laser étant séparés d'une deuxième distance prédéterminée lorsqu'ils frappent ledit élément de synthèse de faisceaux, et
une partie de sortie (7c) à partir de laquelle le premier faisceau laser émergeant de la première partie d'entrée et ledit au moins un autre faisceau laser émergeant de ladite au moins une autre partie d'entrée sont combinés et émis en tant que faisceau laser combiné ; et
une fibre optique (8) positionnée pour recevoir le faisceau laser combiné dans celle-ci,
dans lequel ladite deuxième distance prédéterminée est supérieure à ladite première distance prédéterminée ; et
dans lequel la première bande d'émission de lumière et au moins une autre bande d'émission de lumière dans le dispositif laser à semi-conducteurs (2) ne sont pas séparées de plus de 100 μm.

2. Module de laser à semi-conducteurs selon la revendication 1, dans lequel les plans de polarisation du premier faisceau laser et dudit au moins un autre faisceau laser coïncident l'un avec l'autre.

3. Module de laser à semi-conducteurs selon la revendication 1, comprenant en outre : une deuxième lentille (16) configurée pour coupler le faisceau laser combiné à la fibre optique.

4. Module de laser à semi-conducteurs (M1) selon la revendication 3, dans lequel :

   la première lentille (4) et la deuxième lentille (16) sont positionnées de sorte que le premier faisceau laser (K1) et ledit au moins un autre faisceau laser (K2) soient focalisés en un point entre la première lentille et la deuxième lentille.

5. Module de laser à semi-conducteurs selon l'une quelconque des revendications précédentes, dans lequel : la première lentille (4) est positionnée de sorte qu'un axe optique du premier faisceau laser émis par la première bande d'émission de lumière (9) et un axe optique dudit au moins un autre faisceau laser émis par ladite au moins une autre bande d'émission de lumière (10) soient sensiblement symétriques autour d'un axe central de la première lentille.

6. Module de laser à semi-conducteurs (M1) selon l'une quelconque des revendications précédentes, comprenant en outre : un élément de réception de lumière (3) positionné pour recevoir une lumière émise par la première bande d'émission de laser (9) et ladite au moins une autre bande d'émission de laser (10).

7. Module de laser à semi-conducteurs selon la revendication 6, dans lequel : l'élément de réception de lumière (3) est positionné pour recevoir et surveiller le premier faisceau laser (K1) et ledit au moins un autre faisceau laser (K2) émis à partir d'une autre surface de bord (2b) du dispositif laser à semi-conducteurs.

8. Module de laser à semi-conducteurs (M1) selon l'une quelconque des revendications 6 à 7, dans lequel : l'élément de réception de lumière (3) est un élément de réception de lumière à guide d'ondes.

9. Module de laser à semi-conducteurs selon l'une quelconque des revendications 6 à 8, comprenant en outre : une lentille (95) disposée entre le dispositif laser à semi-conducteurs (2 ; 68 ; 84 ; 85) et l'élément de réception de lumière (3) pour séparer le premier faisceau laser et ledit au moins un autre faisceau laser de manière à étendre une séparation entre le premier faisceau laser et ledit au moins un autre faisceau laser.

10. Module de laser à semi-conducteurs selon l'une quelconque des revendications 6 à 9, dans lequel : l'élément de réception de lumière (3) est configuré pour recevoir et surveiller les parties respectives du premier faisceau laser (K1) et dudit au moins un autre faisceau laser (K2) réfléchies par un composant optique arbitraire agencé entre le dispositif laser à semi-conducteurs et la fibre optique (8).

11. Module de laser à semi-conducteurs (M1) selon l'une quelconque des revendications précédentes, dans lequel : la première bande d'émission de lumière (9) et ladite au moins une autre bande d'émission de lumière (10) dans le dispositif laser à semi-conducteurs (2) s'étendent parallèlement l'une à l'autre.

12. Module de laser à semi-conducteurs selon l'une quelconque des revendications précédentes, dans lequel : la première bande d'émission de lumière (9) et ladite au moins une autre bande d'émission de lumière (10) sont les seules bandes d'émission de lumière dans le dispositif laser à semi-conducteurs.

13. Module de laser à semi-conducteurs selon l'une quelconque des revendications précédentes, dans lequel : la première bande d'émission de lumière (9) et ladite au moins une autre bande d'émission de lumière (10) dans le dispositif laser à semi-conducteurs sont inclinées l'une par rapport à l'autre.

14. Module de laser à semi-conducteurs (M1) selon l'une quelconque des revendications précédentes, dans lequel : la première bande d'émission de lumière (9) et ladite au moins une autre bande d'émission de lumière (10) dans le dispositif laser à semi-conducteurs sont configurées pour être commandées simultanément.

15. Module de laser à semi-conducteurs selon l'une quelconque des revendications précédentes, dans lequel : la première bande d'émission de lumière (9) et ladite au moins une autre bande d'émission de lumière (10) dans le dispositif laser à semi-conducteurs (2) sont configurées pour être commandées de façon indépendante de manière à isoler électriquement au moins un côté d'une électrode positive et d'une électrode négative de la première bande d'émission de lumière et de ladite au moins une autre bande d'émission de lumière.

16. Module de laser à semi-conducteurs (M1) selon l'une quelconque des revendications précédentes, dans lequel : le dispositif laser à semi-conducteurs (2) est un laser à hétérostructure enfouie BH de la série InP.

17. Module de laser à semi-conducteurs selon l'une quelconque des revendications 1 à 15, dans lequel : le dispositif laser à semi-conducteurs (2) est un laser à guide d'ondes-évidement de la série GaAs.

18. Module de laser à semi-conducteurs (M1) selon l'une quelconque des revendications précédentes, dans lequel : le dispositif laser à semi-conducteurs (2) est configuré pour fonctionner en tant que source de lumière de pompage dans une plage inclusive de 1300 nm à 1550 nm pour un amplificateur Raman.

19. Module de laser à semi-conducteurs selon l'une quelconque des revendications précédentes, dans lequel : le dispositif laser à semi-conducteurs (2) est configuré pour fonctionner en tant que source de lumière de pompage dans au moins l'une d'une bande de 980 nm et d'une bande de 1480 nm pour un amplificateur EDFA.

20. Module de laser à semi-conducteurs (M1) selon l'une quelconque des revendications précédentes, dans lequel : l'élément de synthèse de faisceaux (59 ; 60) comprend au moins l'un d'un combineur de faisceaux de polarisation (7) et d'un prisme (5).

21. Module de laser à semi-conducteurs selon la revendication 20, dans lequel : le combineur de faisceaux de polarisation (7) est un élément biréfringent configuré pour propager l'un quelconque du premier faisceau laser (K1) et dudit au moins un autre faisceau laser (K2) en tant que rayon normal et pour propager un autre dudit au moins un du premier faisceau laser et dudit au moins un autre faisceau laser en tant que rayon extraordinaire.

22. Module de laser à semi-conducteurs (M1) selon l'une quelconque des revendications précédentes, dans lequel : la première partie d'entrée (7a) et ladite au moins une autre partie d'entrée (7b) de l'élément de synthèse de faisceaux (7 ; 59 ; 60) sont inclinées l'une par rapport à l'autre.

23. Module de laser à semi-conducteurs (M1) selon l'une quelconque des revendications précédentes, dans lequel : la première partie d'entrée (7a) et ladite au moins une autre partie d'entrée (7b) de l'élément de synthèse de faisceaux sont une partie commune qui est perpendiculaire à une direction axiale optique du module de laser à semi-conducteurs.

24. Module de laser à semi-conducteurs (M2 ; M3) selon l'une quelconque des revendications 1 à 22, dans lequel : la première partie d'entrée (7a) et ladite au moins une autre partie d'entrée (7b) de l'élément de synthèse de faisceaux sont une partie commune qui n'est pas perpendiculaire à une direction axiale optique du module de laser à semi-conducteurs.

25. Module de laser à semi-conducteurs selon l'une quelconque des revendications précédentes, dans lequel : l'élément de synthèse de faisceaux est en outre configuré pour multiplexer au moins trois faisceaux laser.

26. Module de laser à semi-conducteurs selon l'une quelconque des revendications précédentes, comprenant en outre : un prisme de correction de trajet optique (96) positionné entre la première lentille (4) et l'élément de synthèse de faisceaux.

27. Module de laser à semi-conducteurs selon l'une quelconque des revendications précédentes, dans lequel : le dispositif laser à semi-conducteurs (2) et la première lentille (4) sont disposés avec des inclinaisons selon des angles prédéterminés par rapport à une direction axiale optique du module de laser à semi-conducteurs (M3) de sorte que le premier faisceau laser (K1) soit dirigé pour se propager dans une direction axiale de la fibre optique (8).

28. Module de laser à semi-conducteurs (M1 ; M2 ; M3) selon l'une quelconque des revendications précédentes, comprenant en outre : un prisme disposé entre la première lentille et l'élément de synthèse de faisceaux positionné pour recevoir et collimater le premier faisceau laser et ledit au moins un autre faisceau laser.

29. Module de laser à semi-conducteurs selon l'une quelconque des revendications précédentes, comprenant en outre : un élément de rotation de polarisation positionné entre la première lentille et l'élément de synthèse de faisceaux, dans lequel l'élément de rotation de polarisation est configuré pour faire tourner un plan de polarisation d'au moins l'un du premier faisceau laser et dudit au moins un autre faisceau laser.

30. Module de laser à semi-conducteurs selon la revendication 29, dans lequel : l'élément de rotation de polarisation est une lame demi-onde.

31. Module de laser à semi-conducteurs (M1 ; M2 ; M3) selon l'une quelconque des revendications précédentes, comprenant en outre : une partie de réflexion de faisceau (15) configurée pour réfléchir une longueur d'onde prédéterminée du faisceau laser combiné vers le dispositif laser à semi-conducteurs (2 ; 68 ; 84 ; 85).

32. Module de laser à semi-conducteurs selon la revendication 31, dans lequel : la partie de réflexion de faisceau (15) comprend un réseau de Bragg à fibres.

33. Module de laser à semi-conducteurs selon l'une quelconque des revendications précédentes, dans lequel : la fibre optique (8) est une fibre maintenant la polarisation.

34. Module de laser à semi-conducteurs selon l'une quelconque des revendications précédentes, dans lequel : au moins l'une de la première bande d'émission de lumière (9) et de ladite au moins une autre bande d'émission de lumière (9) du dispositif laser à semi-conducteurs comprend un réseau de diffraction (75).

35. Module de laser à semi-conducteurs selon la revendication 34, dans lequel : les réseaux de diffraction (75) d'au moins l'une de la première bande d'émission de lumière (9) et de ladite au moins une autre bande d'émission de lumière (10) du dispositif laser à semi-conducteurs (68) sont disposés uniformément sur une longueur de cavité entière (LR) du dispositif laser à semi-conducteurs.

36. Module de laser à semi-conducteurs selon l'une quelconque des revendications 34 à 35, dans lequel : les réseaux de diffraction (75) d'au moins l'une de la première bande d'émission de lumière (9) et de ladite au moins une autre bande d'émission de lumière (10) du dispositif laser à semi-conducteurs s'étendent le long d'une longueur de cavité du dispositif laser à semi-conducteurs d'au moins 800 $\mu$m et sont configurés pour produire une pluralité de modes d'oscillation longitudinale (83) dans une bande de longueur d'onde (82) prédéterminée.

37. Module de laser à semi-conducteurs selon la revendication 34, dans lequel : les réseaux de diffraction (75) d'au moins l'une de la première bande d'émission de lumière et de ladite au moins une autre bande d'émission de lumière du dispositif laser à semi-conducteurs (84) sont disposés uniformément sur au moins une partie, mais pas une longueur entière, d'une longueur de cavité du dispositif laser à semi-conducteurs (2).

38. Module de laser à semi-conducteurs selon la revendication 34, dans lequel : le réseau de diffraction (75) d'au moins l'une de la première bande d'émission de lumière et de ladite au moins une autre bande d'émission de lumière du dispositif laser à semi-conducteurs (85) comprend une période de réseau périodiquement modifiée.

39. Module de laser à semi-conducteurs selon l'une quelconque des revendications 34 à 38, dans lequel : les réseaux de diffraction (75) de la première bande d'émission de lumière (9) et de ladite au moins une autre bande d'émission de lumière (10) du dispositif laser à semi-conducteurs (68 ; 84 ; 85) sont configurés de sorte que les longueurs d'onde émises par la première bande d'émission de lumière et ladite au moins une autre bande d'émission de lumière soient fixées de manière sélective pour être une même longueur d'onde.

40. Module de laser à semi-conducteurs (M1 ; M2 ; M3) selon l'une quelconque des revendications 34 à 38, dans lequel : les réseaux de diffraction (75) de la première bande d'émission de lumière et de ladite au moins une autre bande d'émission de lumière du dispositif laser à semi-conducteurs (68 ; 84 ; 85) sont configurés de sorte que les longueurs d'onde émises par la première bande d'émission de lumière et ladite au moins une autre bande d'émission de lumière soient fixées de manière sélective pour être différentes.

41. Module de laser à semi-conducteurs selon l'une quelconque des revendications précédentes, dans lequel : la première bande d'émission de lumière et ladite au moins une autre bande d'émission de lumière dans le dispositif laser à semi-conducteurs (2) sont configurées pour être commandées de façon indépendante de manière à isoler électriquement au moins un côté d'une électrode positive et d'une électrode négative de la première bande d'émission de lumière (9) et de ladite au moins une autre bande d'émission de lumière (10).

42. Module de laser à semi-conducteurs selon l'une quelconque des revendications 1 à 30 ou 33 à 41, comprenant en outre : un isolateur optique (94) positionné entre la première lentille (4) et l'élément de synthèse de faisceaux où le premier faisceau laser (K1) et ledit au moins un autre faisceau laser (K2) sont parallèles l'un à l'autre, dans lequel l'isolateur optique est configuré pour stabiliser le module de laser à semi-conducteurs en empêchant une réflexion du faisceau laser.

43. Module de laser à semi-conducteurs selon l'une quelconque des revendications précédentes, comprenant en outre : un dispositif de refroidissement (20) configuré pour refroidir le dispositif laser à semi-conducteurs ; et un module de plaques de base comportant une première plaque de base (17) sur laquelle le dispositif laser à semi-conducteurs est fixé et une deuxième plaque de base (18) disposée sur la première plaque de base et sur laquelle l'élément de synthèse de faisceaux (59 ; 60) est fixé.

44. Module de laser à semi-conducteurs selon la revendication 43, dans lequel : le dispositif de refroidissement est un dissipateur de chaleur comprenant une pluralité d'éléments Peltier disposés sous le module de plaques de base ; et le dispositif de refroidissement (20) est configuré pour maintenir une température constante et pour augmenter et stabiliser le premier faisceau laser (K1) et ledit au moins un autre faisceau laser (K2) émis par le dispositif laser à semi-conducteurs.

45. Module de laser à semi-conducteurs selon l'une quelconque des revendications 43 à 44, comprenant en outre : une thermistance (20a) configurée pour détecter une variation de la température en raison de la chaleur transférée à partir du dispositif laser à semi-conducteurs et pour appliquer un signal au dispositif de refroidissement.

Fig.1 (A)

Fig.1 (B)

Fig.2

L1

5

5a

5b

Fig.3 (A)

5b

5

α

5a

α

5b

Fig.3 (B)

Fig.4 (A)

Fig.4 (B)

Fig.4 (C)

FIG. 5

Fig.6

Fig.7 (A)

Fig.7 (B)

Fig.8 (A)

Fig.8 (B)

Fig.8 (C)

Fig.9

Fig.10

Fig.11

EP 1 215 783 B1

Fig.12

Fig.13

Fig.14

Fig.15 (A)

Fig.15 (B)

Fig.15 (C)

Fig.16

Fig.17 (A)

Fig.17 (B)

EP 1 215 783 B1

Fig.18 (A)

84a

73
72
75
71
LG1
70
80
69
81
LR

Fig.18 (B)

84b

75
73
72
71
LG2
70
80
69
81
LR

Fig.18 (C)

84c

75
73
72
75
71
LG4
LG3
70
80
69
81
LR

Fig.19

Fig. 20

Fig.21 (A)

75a

∧2 ∧1 ∧2 ∧1 ∧2

...

Fig.21 (B)

75b

∧1 ∧2 ∧1

...

Fig.21 (C)

75c

∧1 ∧2

... ...

Fig.22 (A)

Fig.22 (B)

EP 1 215 783 B1

Fig.23

Fig.24

Fig.25

Fig.26 (A)

Fig.26 (B)

Fig.26 (C)

Fig.27 (A)

Fig.27 (B)

Fig.27 (C)

Fig.28

FIG.29 (A)

FIG.29 (B)

Fig.30

96

FIG.31 (A)

$\Delta y$

$\Delta z$

L

$\theta_{yz}'$

$\theta_{yz}$

$\theta_{yz} - \theta_{yz}'$

$\Delta y$

96

FIG.31 (B)

Y

Z

X

FIG.32

Fig.33

Fig.34

Fig.35

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5589684 A
- US 5291571 A
- JP 2000012952 A
- JP 60076707 A
- JP 10062720 A
- JP 2000031575 A